(19) Europäisches Patentamt / European Patent Office / Office européen des brevets

(11) **EP 1 354 325 B1**

(12) **EUROPÄISCHE PATENTSCHRIFT**

(45) Veröffentlichungstag und Bekanntmachung des Hinweises auf die Patenterteilung:
**14.04.2010   Patentblatt 2010/15**

(21) Anmeldenummer: **02722029.2**

(22) Anmeldetag: **23.01.2002**

(51) Int Cl.:
***G21K 1/06*** *(2006.01)*

(86) Internationale Anmeldenummer:
**PCT/EP2002/000608**

(87) Internationale Veröffentlichungsnummer:
**WO 2002/065482 (22.08.2002 Gazette 2002/34)**

(54) **KOLLEKTOR MIT UNGENUTZTEM BEREICH FÜR BELEUCHTUNGSSYSTEME MIT EINER WELLENLÄNGE KLEINER ODER GLEICH 193 nm.**

COLLECTOR WITH AN UNUSED AREA FOR LIGHTING SYSTEMS HAVING A WAVELENGTH INFERIOR OR EQUAL OF 193 NM

COLLECTEUR PRESENTANT UNE ZONE INUTILISEE, DESTINE A DES SYSTEMES D'ECLAIRAGE DE LONGUEUR D'ONDE INFERIEUR OU EGAL A 193 NM.

(84) Benannte Vertragsstaaten:
**DE NL**

(30) Priorität: **23.01.2001   DE 10102934**
**06.06.2001   DE 10127298**
**10.08.2001   DE 10138313**

(43) Veröffentlichungstag der Anmeldung:
**22.10.2003   Patentblatt 2003/43**

(73) Patentinhaber: **Carl Zeiss SMT AG**
**73447 Oberkochen (DE)**

(72) Erfinder:
• **SINGER, Wolfgang**
**73431 Aalen (DE)**
• **EGLE, Wilhelm**
**73432 Aalen (DE)**

• **WEISS, Markus**
**73430 Aalen (DE)**
• **HAINZ, Joachim**
**73430 Aalen (DE)**
• **WIETZORREK, Jochen**
**73430 Aalen (DE)**
• **MELZER, Frank**
**73469 Utzmemmingen (DE)**
• **WANGLER, Johannes**
**89551 Königsbronn (DE)**

(74) Vertreter: **Sawodny, Michael-Wolfgang**
**Adolf - Lüken - Höflich - Sawodny**
**Dreiköniggasse 10**
**89073 Ulm (DE)**

(56) Entgegenhaltungen:
**EP-A- 0 724 150     EP-A- 0 955 641**
**US-A- 5 192 869**

## Beschreibung

Die Erfindung betrifft einen Kollektor für Beleuchtungssysteme mit einer Wellenlänge ≤ 193 nm, bevorzugt ≤ 126 nm, insbesondere bevorzugt Wellenlängen im EUV-Bereich zur Aufnahme des von einer Lichtquelle abgestrahlten Lichtes und zur Ausleuchtung eines Bereiches in einer Ebene mit einer Vielzahl von rotationssymmetrischen Spiegelschalen, welche um eine gemeinsame Rotationsachse ineinander angeordnet sind. Jeder Spiegelschale ist ein Ringaperturelement der objektseitigen Apertur zugeordnet. Die rotationssysmmetrischen Spiegelschalen umfassen mindestens ein erstes Spiegelsegment mit mindestens einer ersten optischen Fläche. Der ersten optischen Fläche ist ein Anfangs- und ein Endpunkt bezogen auf die Rotationsachse zugeordnet, wobei der Anfangspunkt einen äußeren Randstrahl und der Endpunkt einen inneren Randstrahl definiert. Innerer und äußerer Randstrahl begrenzen ein Lichtbüschel, das an der ersten optischen Fläche der Spiegelschale reflektiert wird und den Kollektor von der objektseitigen Apertur zum auszuleuchtenden Bereich in einer Ebene durchläuft. Das Lichtbüschel definiert einen genutzten Bereich zwischen zwei benachbarten Spiegelschalen.

Des weiteren stellt die Erfindung auch ein Beleuchtungssystem mit einem derartigen Kollektor, einer Projektionsbelichtungsanlage mit einem erfindungsgemäßen Beleuchtungssystem sowie ein Verfahren zur Belichtung von Mikrostrukturen zur Verfügung.

Genestete Kollektoren für Wellenlängen ≤ 193 nm, insbesondere Wellenlängen im Bereich der Röntgenstrahlen sind aus einer Vielzahl von Schriften bekanntgeworden.

So zeigt die US 5,768,339 einen Kollimator für Röntgenstrahlen, wobei der Kollimator mehrere genestete paraboloidförmige Reflektoren aufweist. Der Kollimator gemäß der US 5,768,339 dient dazu, ein isotrop abgestrahltes Strahlbündel einer Röntgen-Lichtquelle in einen parallelen Strahl zu formen.

Aus der US-A-1865441 ist ein genesteter Kollektor für Röntgenstrahlen bekanntgeworden, der wie im Falle der US 5,768,339 dazu dient, von einer Quelle abgegebene isotrope Röntgenstrahlen zu einem parallelen Strahlbündel zu kollimieren.

Die US 5,763,930 zeigt einen genesteten Kollektor für eine Pinch-Plasma-Lichtquelle, der dazu dient, die von der Lichtquelle abgegebene Strahlung zu sammeln und in einen Lichtleiter zu bündeln.

Die US 5,745,547 zeigt mehrere Anordnungen von Multikanaloptiken, die dazu dienen, durch Mehrfachreflexionen die Strahlung einer Quelle, insbesondere Röntgenstrahlung, in einem Punkt zu bündeln.

Um eine besonders hohe Transmissioneffizienz zu erreichen, schlägt die Erfindung gemäß der US 5,745,547 elliptisch geformte Reflektoren vor.

Aus der DE 30 01 059 C2 ist für die Verwendung in Röntgenstrahlen-Lithographiesystemen eine Anordnung bekanntgeworden, die parabolische zwischen Röntgenstrahlquelle und Maske angeordnete genestete Spiegel aufweist. Diese Spiegel sind so angeordnet, daß die divergierenden Röntgenstrahlen zu einem parallel verlaufenden Ausgangsstrahlbüschel geformt werden.

Die Anordnung gemäß der DE 30 01 059 dient wiederum lediglich dazu, für die Röntgenstrahl-Lithographie eine gute Kollimation zu erreichen.

Die aus der WO 99/27542 bekanntgewordene Anordnung von genesteten Reflektoren dient bei einem Röntgenstrahl-Proximity-Lithographie-System dazu, daß Licht einer Lichtquelle zu refokussieren, so daß eine virtuelle Lichtquelle ausgebildet wird. Die genesteten Schalen können Ellipsoidform aufweisen.

Aus der US 6,064,072 ist ein genesteter Reflektor für hochenergetische Photonenquellen bekanntgeworden, der dazu dient, die divergierenden Röntgenstrahlen zu einem parallel verlaufenden Strahlbüschel zu formen.

Die WO 00/63922 zeigt einen genesteten Kollektor, der dazu dient, den Neutronenstrahl zu kollimieren.

Aus der WO 01/08162 ist ein genesteter Kollektor für Röntgenstrahlen bekanntgeworden, der sich durch eine Oberflächenrauhigkeit der inneren, reflektierenden Fläche, der einzelnen Spiegelschalen von weniger als 12 Å rms auszeichnet. Die in der WO 01/08162 gezeigten Kollektoren umfassen auch Systeme mit Mehrfachreflexionen, insbesondere auch Woltersysteme, und zeichnen sich durch eine hohe Auflösung, wie sie beispielsweise für die Röntgenlithographie gefordert wird, aus.

Für Beleuchtungsoptiken für die EUV-Lithographie, wie beispielsweise in der DE 199 03 807 oder der WO 99/57732, werden außer an die Auflösung auch hohe Anforderungen an die Gleichmäßigkeit bzw. Uniformität und Telezentrie gestellt. Bei derartigen Systemen wird für bestimmte Lichtquellen das Licht der Lichtquelle durch einen Kollektor gesammelt.

Aus der US 5,192,869 ist eine Linse mit einer Vielzahl von rotationssysmetrischen, Kanäle bildenden Elementen bekannt, die als Kollektor für kurzwellige Strahlung ausgebildet sein kann und bei der in den Kanälen Reflektion der Strahlung erfolgen kann. Aus der US 5,192,869 ist eine Kühlung durch Gas oder Flüssigkeit in einem ungenutzten Bereich zwischen den Kanälen bekannt geworden.

Aufgabe der Erfindung ist es, einen Kollektor für ein Beleuchtungssystem für die Mikrolithographie mit Wellenlängen ≤ 193 nm, vorzugsweise < 126 nm, besonders bevorzugt für Wellenlängen im EUV-Bereich anzugeben, der den hohen Anforderungen an die Uniformität und Telezentrie, die für Beleuchtungsoptiken erforderlich sind, gerecht wird und insbesondere den einbau von weiteren Komponenten wie Auskoppelspiegel, Detektoren oder Elementen ohne optische Wirkung, beispielsweise Abschirmeinrichtungen, Kühleinrichtungen, Detektionseinrichtungen, Befestigungseinrichtungen ermöglicht, wobei die homogene Ausleuchtung in einer bildseitigen Ebene möglichst unbeeinflußt bleiben soll.

Erfindungsgemäß wird diese Aufgabe durch einen Kollektor mit einer objektseitigen Apertur, die von einer Lichtquelle abgestrahltes Licht aufnimmt sowie die Merkmale des Anspruchs 1 umfaßt, gelöst. Der erfindungsgemäße Kollektor umfaßt eine Vielzahl von rotationssymmetrischen Spiegelschalen, welche um eine gemeinsame Rotationsachse ineinander angeordnet sind. Jeder Spiegelschale ist ein Ringaperturelement der objektseitigen Apertur zugeordnet. Die Ausdehnungen der Spiegelschalen in Richtung der Rotationsachse sowie die Flächenparameter und die Positionen der Spiegelschalen derart gewählt, daß zwischen zwei benachbarten Spiegelschalen, einer äußeren Spiegelschale und einer inneren Spiegelschale, ein ungenutzter Bereich ausgebildet wird. Unter ungenutztem Bereich wird in vorliegender Anmeldung der Bereich zwischen zwei Spiegelschalen, einer innere und einer äußerer Spiegelschale verstanden, der nicht von einem Lichtbüschel, das den Kollektor von der Objektseite zur Bildebene durchläuft, genutzt wird. Der ungenutzte Bereich liegt in der Regel auf der Rückseite, d.h. der nicht reflektierenden Seite inneren Spiegelschale. Unter innerer Spiegelschale versteht man die Spiegelschale, die von den beiden Spiegelschalen, der inneren und äußeren Spiegelschale, den geringeren Abstand zur Rotationsachse aufweist

Besonders bevorzugt werden im ungenutzten Bereich Kühleinrichtungen angeordnet, die dazu dienen sollen, eine Erwärmung der Spiegelschalen aufgrund der auftreffenden und teilweise absorbierten Strahlung zu verhindern. Die Wärmelast auf den einzelnen Spiegeln kann bis zu 200° K betragen. Durch die Anordnung der Kühleinrichtungen im ungenutzten Bereich zwischen zwei Spiegelschalen kann ein zusätzlicher Lichtverlust, der durch das Einbringen der Kühleinrichtungen entstehen kann, vermieden werden. Die Ausleuchtung in der auszuleuchtenden Ebene wird somit nicht durch Schatten der Kühleinrichtungen beeinträchtigt. In einer bevorzugten Ausführungsform der Erfindung besteht der auszuleuchtende Bereich in einer Ebene aus Ringelementen und jedem Ringelement ist ein Ringaperturelement zugeordnet und die Ausdehnung der Spiegelschalen in Richtung der Rotationsachse, ihre Flächenparameter und ihre Position sind derart gewählt, daß die Bestrahlungsstärken der einzelnen Ringelemente in der Ebene weitgehend übereinstimmen.

Die Erfinder haben erkannt, daß durch die erfindungsgemäße Ausgestaltung eines genesteten Kollektor in einem Bereich einer Ebene eine weitgehend gleichmäßige Ausleuchtung erreicht werden kann. Besonders bevorzugt ist es, wenn die Spiegelschalen ein ringförmiges Segment eines Ellipsoids, eines Paraboloids oder eines Hyperboloids sind. Für ein Paraboloid ergibt sich ein vollständig paralleles Strahlenbündel und somit eine im Unendlichen liegende Lichtquelle. Will man beispielsweise mit Hilfe eines in der auszuleuchtenden Ebene angeordneten ersten optischen Elementes mit ersten Rasterelementen gemäß dem US-Patent 6 198 793 B1, dessen Offenbarungsgehalt vollständig in die vorliegende Anmeldung mit aufgenommen wird, sekundäre Lichtquellen erzeugen, so müssen bei Spiegelschalen, die als ringförmiges Segment eines Paraboloids ausgebildet sind, die einzelnen Rasterelemente eine sammelnde Wirkung aufweisen.

Die sammelnde Wirkung kann auch auf den Kollektor übertragen werden. Ein derartiger erfindungsgemäßer Kollektor würde Schalen, die Ausschnitte von Ellipsoiden sind, umfassen, so daß ein konvergentes Strahlbündel ausgebildet wird. Durch die Übertragung der sammelnden Wirkung auf einen Kollektor, der Schalen, die Ausschnitte von Ellipsoiden sind, umfaßt, können die ersten Rasterelemente des ersten optischen Elementes beispielsweise als Planfacetten ausgebildet werden.

Kollektoren mit Schalen, die Ausschnitte von Hyperboloide sind, führen zu einem divergierenden Strahlbündel und sind insbesondere dann von Interesse, wenn der Kollektor möglichst klein dimensioniert werden soll.

Im Gegensatz zu den genesteten Kollektoren gemäß dem Stand der Technik zeichnet sich der erfindungsgemäße Kollektor dadurch aus, daß die Ausdehnungen der Reflektoren der unterschiedlichen Schalen in Richtung der Rotationsachse verschieden sind. So kann eine weitgehend homogene Ausleuchtung in einen ringförmigen Bereich in der auszuleuchtenden Ebene realisiert werden. Sind die Abmessungen und Abstände der Reflektoren wie bei dem im einleitenden Teil zitierten Stand der Technik im wesentlichen gleich, so kann zwar beispielsweise ein kollimierter Strahl bzw. ein fokussierter Strahl erreicht werden, eine homogene Ausleuchtung in einem ringförmigen Bereich hingegen nicht. Darüber hinaus können die winkelabhängigen Reflexionsverluste durch geeignete Auslegung des Kollektors kompensiert werden, so daß eine homogene Ausleuchtung in der Ebene erfolgt.

In einer bevorzugten Ausführungsform des erfindungsgemäßen Kollektors ist die Position einer äußeren Spiegelschale von der auszuleuchtenden Ebene weiter entfernt als die Position einer inneren Spiegelschale. Als Position einer Spiegelschale wird dabei der Mittelwert aus Anfangs- und Endpunkt einer Schale bezogen auf die Rotationsachse des Kollektors verstanden. Unter innerer Spiegelschale versteht man die Spiegelschale, die von den beiden Spiegelschalen, der inneren und äußeren Spiegelschale, den geringeren Abstand zur Rotationsachse aufweist.

Da die Homogenisierung auch mit den genesteten Kollektoren lediglich in einer diskreten Näherung erreicht wird, ist es von Vorteil, wenn der Kollektor so viele Schalen als möglich umfaßt. Bevorzugt weist der erfindungsgemäße Kollektor mehr als vier, besonders bevorzugt mehr als sieben und insbesondere bevorzugt mehr als zehn Reflektoren in einer schalenförmigen Anordnung auf.

Bei einer isotrop abstrahlenden Lichtquelle gewährleistet der erfindungsgemäße Kollektor, daß gleiche Winkelsegmente auf gleiche Flächen abgebildet werden. Darüber hinaus können die winkelabhängigen Reflexionsverluste durch geeignete Auslegung des Kollektors kompensiert werden, so daß eine homogene Ausleuchtung in der auszuleuchtenden Ebene vorliegt.

Für eine homogene Ausleuchtung in der auszuleuchtenden Ebene ist es von besonderem Vorteil, wenn die Ringelemente kontinuierlich aneinander anschließen. Eine homogene Ausleuchtung in der Ebene wird auch dann erreicht, wenn die den Ringelementen zugeordneten Ringapurelemente nicht kontinuierlich aneinander anschließen, sondern Lücken aufweisen. Besonders bevorzugt können in diesen Lücken, ohne daß ein Lichtverlust in der auszuleuchtenden Ebene eintritt, weitere Komponenten wie beispielsweise Einrichtungen ohne optische Wirkung, insbesondere Kühleinrichtungen angeordnet werden.

Liegt eine nicht-isotrope Quelle vor, so kann die Abstrahlcharakteristik durch den Kollektor in eine homogene Ausleuchtung umgewandelt werden.

In einer bevorzugten Ausführungsform ist die radiale Ausdehnung von mindestens zwei Ringelementen gleich groß und die Ausdehnung in Richtung der Rotationsachse der dem inneren Ringelement zugeordneten Spiegelschale des Kollektors größer als die Ausdehnung in Richtung der Rotationsachse der dem äußeren Ringelement zugeordneten Spiegelschale des Kollektors. Unter innerem Ringelement versteht man das Ringelement, das von den beiden Ringelementen, dem inneren und dem äußerem Ringelement, den geringeren Abstand zu Rotationsachse aufweist.

Vorteilhafterweise ist der erfindungsgemäße Kollektor derart gestaltet, daß der Quotient aus einem ersten Verhältnis der radialen Ausdehnung eines ersten Ringelementes zur Winkelausdehnung des zugeordneten Ringapurelementes und einem zweiten Verhältnis der radialen Ausdehnung eines zweiten Ringelementes zur Winkelausdehnung des zugeordneten Ringapurelementes gleich groß ist zu dem Quotienten aus einer ersten Strahlstärke, die in das erste Ringapurelement fließt, und aus einer zweiten Strahlstärke, die in das zweite Ringapurelement fließt, d.h. es gilt die Gleichung:

$$\frac{dA_1}{d\Omega_1} \div \frac{dA_2}{d\Omega_2} = I(\alpha_1) \div I(\alpha_2)$$

In einer alternativen Ausführungsform der Erfindung ist vorgesehen, die genesteten Spiegelschalen so auszubilden, daß an einer Spiegelschale Mehrfachreflexionen auftreten.

Durch Mehrfachreflexionen an einer Schale können die Reflexionswinkel klein gehalten werden.

Die Reflektivität verhält sich bei Reflexion unter streifendem Einfall mit kleinen Einfallswinkeln von weniger als 20 relativ zur Oberflächentangente bei Materialien wie Molybdän, Niob, Ruthenium, Rhodium, Palladium oder Gold nahezu linear mit dem Einfallswinkel relativ zur Oberflächentangente, so daß die Reflexionsverluste für eine Reflexion unter beispielsweise 16 oder zwei Reflexionen unter 8 annähernd dieselben sind. Für die maximal erreichbare Apertur des Kollektors ist es jedoch vorteilhaft, mehr als eine Reflexion zu verwenden.

Besonders bevorzugt sind Systeme mit zwei Reflexionen. Kollektoren mit zwei Reflexionen können beispielsweise als genestete Woltersysteme mit ersten Spiegelschalen, die ringförmige Ausschnitte von Hyperboloiden sind, und zweiten Spiegelschalen, die ringförmige Ausschnitte von Ellipsoiden sind, ausgebildet sein.

Woltersysteme sind aus der Literatur, beispielsweise aus Wolter, Annalen der Physik 10, 94 - 114, 1952, bekannt. Betreffend Woltersysteme mit einer reellen Schnittweite, d.h. einem reellen Zwischenbild der Quelle, die durch die Kombination einer Hyperboloidfläche mit einer Ellipsoidfläche gebildet wird, wird auf J. Optics, Vol. 15, 270 - 280, 1984 verwiesen.

Ein besonderer Vorteil von Woltersystemen ist, daß bei einem Woltersystem mit zwei Reflexionen mit Einfallswinkeln kleiner 20 relativ zur Oberflächentangente eine maximale Kollektionsapertur von bis zu $NA_{max}$ 0.985 entsprechend einem Aperturwinkel von 80 gewählt werden kann, wobei man sich immer noch im hochreflektierenden Bereich der Reflexion unter streifendem Einfall mit einer Reflektivität > 70 % befindet.

In einer ersten Ausführungsform der Erfindung ist vorgesehen, daß das erste ringförmige Segment und das zweite ringförmige Segment einer Schale nicht kontinuierlich aneinander anschließen, sondern zwischen erstem und zweitem ringförmigen Segment ein nicht genutzter Bereich der Spiegelschale, eine sogenannte Lücke liegt.

Besonders bevorzugt werden in dem nicht genutzten Bereich der Spiegelschale eines zweischaligen Systems weitere Komponenten, insbesondere Elemente ohne optische Wirkung, insbesondere Kühleinrichtungen angeordnet.

Auch bei einer Anordnung dieser weiteren Komponenten im nicht genutzten Bereich zwischen zwei Segmenten können zusätzliche Lichtverluste vermieden werden.

Besonders bevorzugt ist es, wenn die einzelnen Schalen eines genesteten Kollektors durch Halteeinrichtungen miteinander verbunden sind. Derartige Halteeinrichtungen können beispielsweise radial verlaufende Stützspeichen umfassen. Im Bereich der radial verlaufenden Stützspeichen können Zufuhr- und Abfuhreinrichtungen zur Zufuhr bzw. Abfuhr von Kühlmittel zu bzw. von den Kühleinrichtungen vorgesehen sein. Die Kühleinrichtungen umfassen dann bevorzugt Kühlkanäle. Eine besonders gute Wärmeabfuhr wird dann erzielt, wenn die Kühleinrichtungen als ringförmige Kühlplatten im ungenutzten Bereich zwischen zwei Kollektorschalen angeordnet sind. Die ringförmige Platte kann Kühlleitungen umfassen. Die Kühlleitungen können im Schatten der Stege der Halteeinrichtungen nach außen geführt werden. Die Platten können in einer bevorzugten Ausführungsform mit der Spiegelschale beispielsweise durch galvanisches Aufwachsen physikalisch verbunden sein. Dann erfolgt der Abtransport der Wärme über Wärmeleitung. Alternativ hierzu können die Kühlplatten auch nur auf die Spiegelschalen aufgelegt sein. Dies ist insbesondere dann von Vorteil, wenn es aufgrund der Wärmeausdehnung zwischen Kühleinrichtung und Spiegelschale zu Deformationen kommen würde. Ein Abtransport der Wärme erfolgt dann nicht über Wärmeleitung, sondern über Strahlung. Der Vorteil von ringförmigen Kühlplatten liegt in einer großflächigen und damit effektiven Kühlung. Des weiteren wird durch eine derartige Anordnung eine rotationssymmetrische homogene Kühlung erreicht. Die optische Qualität wird durch eine derartige Kühlanordnung nur in sehr geringem Maße beeinflußt.

Neben dem Kollektor stellt die Erfindung auch ein Beleuchtungssystem mit einem derartigen Kollektor zur Verfügung. Das Beleuchtungssystem ist bevorzugt ein doppelt facettiertes Beleuchtungssystem mit einem ersten optischen Element mit ersten Rasterelementen und einem zweiten optischen Element mit zweiten Rasterelementen, wie in der US 6,198,793 B1 gezeigt, deren Offenbarungsgehalt vollumfänglich in die Anmeldung mit aufgenommen wird.

Die ersten und/oder zweiten Rasterelemente können Planfacetten oder Facetten mit sammelnder bzw. zerstreuender Wirkung sein.

In einer Ausführungsform der Erfindung kann vorgesehen sein, daß auf dem ersten optischen Element mit ersten Rasterelementen nur ein ringförmiger Bereich ausgeleuchtet wird. Die ersten Rasterelemente sind dann bevorzugt innerhalb des ringförmigen Bereiches angeordnet.

Das Beleuchtungssystem umfassend den erfindungsgemäßen Kollektor findet bevorzugt in einer Projektionsbelichtungsanlage für die Mikrolithographie Verwendung, wobei eine derartige Projektionsbelichtungsanlage in der PCT/EP 00/07258 gezeigt ist, deren Offenbarungsgehalt vollumfänglich in die vorliegende Anmeldung mit aufgenommen wird. Projektionsbelichtungsanlagen umfassen ein der Beleuchtungseinrichtung nachgeordnetes Projektionsobjektiv, beispielsweise ein 4-Spiegel-Projektionsobjektiv wie in der US 6,244,717 B1 dargestellt, deren Offenbarungsgehalt vollumfänglich in die vorliegende Anmeldung mitaufgenommen wird.

Die Erfindung soll nachfolgend anhand der Zeichnungen beispielhaft beschrieben werden.

Es zeigen:

Figur 1      eine Prinzipskizze eines Kollektors
Figur 2      Skizze der Ringaperturelementes um eine Lichtquelle
Figur 3      Skizze der Ringelemente in einer Ebene
Figur 4      genesteter Kollektor aus Ellipsoidsegmenten
Figur 5      genesteter Kollektor aus Ellipsoidsegmenten mit unterschiedlicher Schalenzahl wie in Figur 4
Figur 6      refraktiver genesteter Kollektor
Figur 7      i-tes Ellipsensegment eines genesteten Kollektors
Figur 8      Ellipsenschar eines genesteten Kollektors gemäß Ausführungsbeispiel in Tabelle 1
Figur 9      Abbildungsmaßstab $\beta$ des Ausführungsbeispieles gemäß Tabelle 1 in Abhängigkeit vom bildseitigen Aperturwinkel
Figur 10     Abbildungsmaßstab $\beta$ des Ausführungsbeispieles gemäß Tabelle 1 in Abhängigkeit vom Radius r in der Ebene 7 in x-Richtung
Figur 11     Projektionsbelichtungsanlage mit einem genesteten Kollektor gemäß der Erfindung
Figur 12     Ausleuchtungsverteilung (Bestrahlungsstärke) der Ringelemente in der Ebene der ersten Rasterelemente der Projektionsbelichtungsanlage gemäß Figur 11 in Abhängigkeit vom radialen Abstand zur Rotationsachse z des Systems
Figur 13     Projektionsbelichtungsanlage mit Zwischenbild mit einem genesteten Kollektor
Figur 14     Abbildungsmaßstab $\beta$ eines 8-schaligen genesteten Woltersystems gemäß Figur 17
Figur 15     auszugsweise Darstellung von drei Schalen aus einem genesteten Woltersystem
Figur 16     auszugsweise Darstellung von zwei Schalen aus einem genesteten Woltersystem
Figur 17     8-schaliges genestetes Woltersystem
Figur 18     Skizze zur Erläuterung der Koordinaten einer Kollektorschale, ausgeführt als Woltersystem mit zwei Reflexionen
Figur 19     Ausleuchtungsverteilung (Bestrahlungsstärke) der Ringelemente in der Ebene der ersten Rasterelemente eines Systems gemäß Figur 20 mit einem Kollektor gemäß Figur 17
Figur 20     EUV-Projektionsbelichtungsanlage mit einem genesteten Kollektor gemäß Figur 17

Figur 21    Koordinatensysteme aller Spiegel der EUV-Projektionsbelichtungsanlage gemäß Figur 20 mit dem genesteten Kollektor gemäß Figur 17

Figur 22    erstes optisches Element eines Beleuchtungssystems gemäß Figur 20 mit ersten Rasterelementen

Figur 23    zweites optisches Element eines Beleuchtungssystems gemäß Figur 20 mit zweiten Rasterelementen

Figur 24    ein 2-schaliges genestetes Woltersystem mit Kühleinrichtungen

Figur 25    ein 2-schaliger genesteter Ellipsoidkollektor mit Kühleinrichtungen

Figur 26    Kühlringe mit Haltestruktur

In der vorliegenden Anmeldung werden die in nachfolgender Tabelle aufgeführten lichttechnischen Begriffe, nach Naumann/Schröder, "Bauelemente der Optik", Hauser-Verlag 1992, S. 28-29 verwandt.

Tabelle 1: Lichttechnische Begriffe

| Physikalische Größe | Formel | Einheit |
|---|---|---|
| Strahlungsfluß $\Phi_e$ (Radiant Flux) | $\phi_E = \dfrac{\partial Q}{\partial t}$ | Watt [W] |
| Bestrahlungsstärke $E_e$ (Irradiance oder Flux density) | $E_e = \dfrac{d\,\phi_e}{d\,Ao}$ | Watt / cm$^2$ |
| Strahlstärke $I_e$ (Radiant Intensity) | $I_e = \dfrac{d\,\phi_e}{d\,\Omega}$ | Watt / Sterradian |
| Strahldichte $L_e$ (Radiance) | $L_e = \dfrac{d\,\phi_e}{d\,A_s \cdot \cos\alpha\, d\Omega}$ | Watt / cm$^2$ /Sterradian |

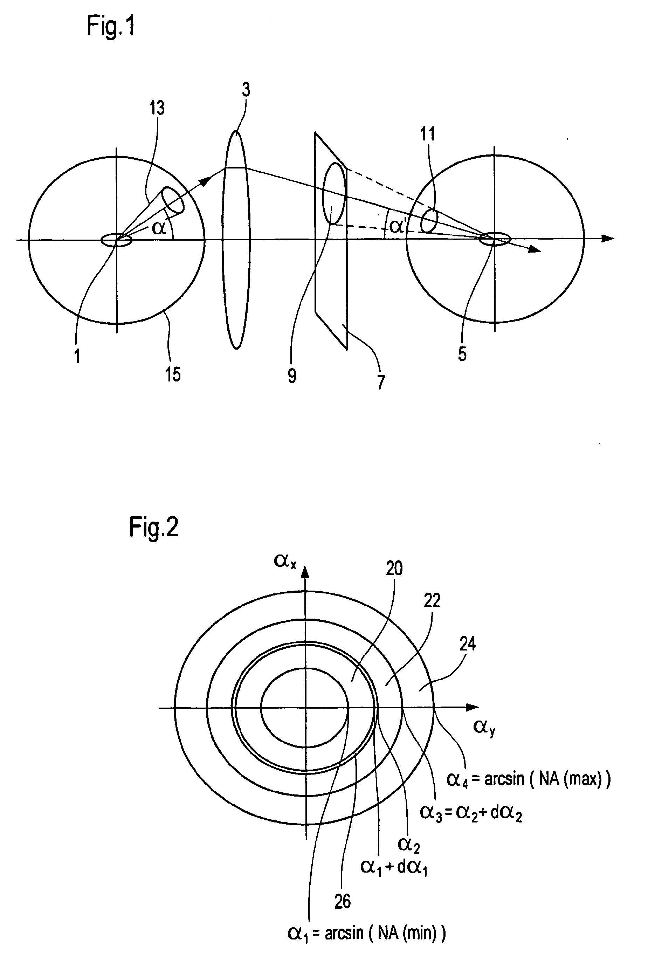

In Figur 1 ist eine Prinzipskizze eines Systems mit Lichtquelle 1, Kollektor 3, Quellbild 5 und Zwischenebene 7 gezeigt. Die Lichtquelle 1 strahlt in den Raum mit einer bestimmten Strahlstärke ab. Diese hängt im allgemeinen vom Winkel $\alpha$ und $\phi$ (Winkel um die z-Achse, nicht eingezeichnet) ab:
$I(\alpha\ \phi)$.

Bei axialsymmetrischen Lichtquellen gilt:

$$I(\alpha\ \phi) = I(\alpha).$$

Der nachfolgende Kollektor 3 sammelt das ausgestrahlte Licht und bündelt es. Er bildet die Lichtquelle 1 ab, wobei das Lichtquellenbild 5 entweder reell - wie in Figur 1 dargestellt - oder virtuell sein kann. Auch kann es sich bei der Lichtquelle 1 bereits um ein Bild einer physikalischen Lichtquelle handeln. In einer Ebene 7 hinter dem Kollektor 3 erhält man in beiden Fällen eine bestimmte Ausleuchtung 9, welche der Projektion der Strahlstärke des Strahlungskegels 11, das ist das Raumwinkelelement unter dem Winkel $\alpha'$ im Bildraum des Kollektors, entspricht.

Wenn in einer Ebene 7 die Ausleuchtung homogenisiert ist, so ist sie es automatisch auch in jeder anderen Ebene hinter dem Kollektor, sofern sie hinreichend weit entfernt ist von der Bildebene, in der das Bild 5 der Lichtquelle 1 liegt. Dem Strahlungskegel 11 im Bildraum entspricht ein zugehöriger Strahlungskegel 13 im Objektraum, gefüllt mit der abgestrahlten Quell-Strahlstärke I ($\alpha$) in das Raumwinkelelement unter dem Winkel $\alpha$.

Gemäß der Erfindung wird eine beliebige Lichtquelle 1 in ein Bild der Quelle abgebildet. Das Quellbild kann reell (d.h. in Lichtrichtung rechts vom Kollektor 3) oder virtuell (d. h. in Lichtrichtung links vom Kollektor 3) sein oder im Unendlichen liegen.

In einer bevorzugten Ausführungsform der Erfindung die Abstrahlcharakteristik einer beliebigen Lichtquelle 1 so umtransformiert, daß sich in einer Ebene vor oder hinter dem Zwischenbild eine weitgehend homogene Ausleuchtung ergibt.

Gemäß der Erfindung soll gelten

$$(2.1) \qquad E = \frac{\phi}{dA} = \frac{R(\alpha)\,I^*(\alpha)\,d\Omega}{dA} = const.$$

E: Bestrahlungsstärke in der Ebene 7
$\phi$: Strahlungsfluß
dA: Flächenelement in Ebene 7
$d\Omega$: Winkelelement in der objektseitigen Apertur
$I^*(\alpha)$: Strahlstärke der Quelle unter dem Winkel
$R(\alpha)$: Abschwächungsfaktor proportional zu Lichtverlusten durch die endliche, winkelabhängige Reflektivität des Kollektors (im folgenden wird o.B.d.A. $I(\alpha) = R(\alpha) \times I^*(\alpha)$ verwendet)

Für zwei Ringelelemente mit gleicher Bestrahlungsstärke muß also gelten:

$$(2.2) \qquad E = \frac{\phi_1}{dA_1} = \frac{I(\alpha_1)\,d\Omega_1}{dA_1} = \frac{\phi_2}{dA_2} = \frac{I(\alpha_2)\,d\Omega_2}{dA_2}$$

woraus die Beziehung folgt:

$$(2.3) \qquad \frac{d\Omega_2}{dA_2} \div \frac{d\Omega_1}{dA_1} = I(\alpha_1) \div I(\alpha_2)$$

Bei anisotropen Quellen oder starken Unterschieden in den Reflexionsverlusten $R(\alpha)$ müssen die Ringapertursegmente bzw. Ringelemente auf Ebene 7 entsprechend Gl. (2.3) gewählt werden.

Im allgemeinen kann die Aufgabe, ein Zwischenbild zu erzeugen und gleichzeitig eine Abstrahlcharakteristik anzupassen, nicht mit einfachen optischen Elementen wie z. B. einem Spiegel oder einer Linse, erfüllt werden. Bei um die z-Achse, die vorliegend identisch mit der optische Achse des Systems ist, rotationssymmetrischen Abstrahlcharakteristiken kann über eine spezielle Art von Fresnel-Optik zumindest für diskrete Bereiche eine gleiche Ausleuchtung erzielt werden.

Dies wird im folgenden am Beispiel eines reellen Zwischenbildes der Quelle 1 erläutert. Für virtuelle Zwischenbilder oder Quellbild im Unendlichen ergeben sich für den Fachmann in naheliegender Art und Weise ähnliche Konstruktionen.

Man wählt, um die Quelle 1 beispielsweise drei Winkelsegmente bzw. Ringaperturelemente 20, 22, 24 wie in Fig. 2 gezeigt. Der Strahlungsfluß durch die Ringaperturelemente ist gegeben durch:

$$(2.4a) \qquad \Phi_i = \int\limits_{\varphi=0}^{2\pi} \int\limits_{\alpha=\alpha_i}^{\alpha_{i+1}} I^*(\alpha,\varphi)\,d\Omega$$

Bei den meist vorliegenden rotationssymmetrischen Quellen, dereren Strahlstärke nur schwach mit dem Winkel $\alpha$ variiert, wie z.B. der Dense Plasma Focus Quelle kann der Strahlungsfluß näherunsweise beschrieben werden durch:

$$(2.4b) \quad \Phi_i \approx 2\pi I^*(\alpha_i) \cdot (\cos\alpha_i - \cos\alpha_{i+1})$$

wobei

$\phi_i$:      Strahlungsfluß

$I^*(\alpha_i)$:      Strahlstärke der Quelle unter dem Winkel $\alpha_i$

$\alpha_i$:      innerer Winkel des i-ten Winkelsegmentes,

$\alpha_{i+1}$:      äußerer Winkel des i-ten Segmentes mit $\alpha_{i+1} = \alpha_i + d\alpha_i$

$d\alpha_i$:      Breite des i-ten Winkelsegmentes

Über Gleichung (2.4) werden die im allgemeinen unterschiedlichen Winkelinkremente $d\alpha_i$ bestimmt, so dass die Bestrahlungsstärke in den zugeordneten Ringelementen in Ebene 7 weitgehend gleich ist.

In Figur 2 sind die Ringapertursegmente 20, 22, 24 gezeigt. Dargestellt ist ein Beispiel mit drei Segmenten 20, 22, 24 die zwischen $NA_{min}$ und $NA_{max}$ liegen. Die Segmente 22 und 24 schließen aneinander an. Zwischen den Segmenten 20 und 22 besteht eine kleine Lücke 26.

Den einzelnen Ringapertursegmenten bzw. Ringaperturelementen 20, 22, 24 sind in der auszuleuchtenden Ebene 7 Ringelemente 30, 32, 34 zugeordnet, wobei im allgemeinen gilt

$$(2.5) \qquad r_{i+1} = r_i + dr_i$$

wobei

$r_i$:      innerer Abstand des i-ten Ringelementes in der auszuleuchtenden Ebene 7

$r_{i+1}$:      äußerer Abstand des i-ten Ringelementes in der auszuleuchtenden Ebene 7

$dr_i$:      Höheninkrement oder radiale Ausdehnung des i-ten Ringelementes

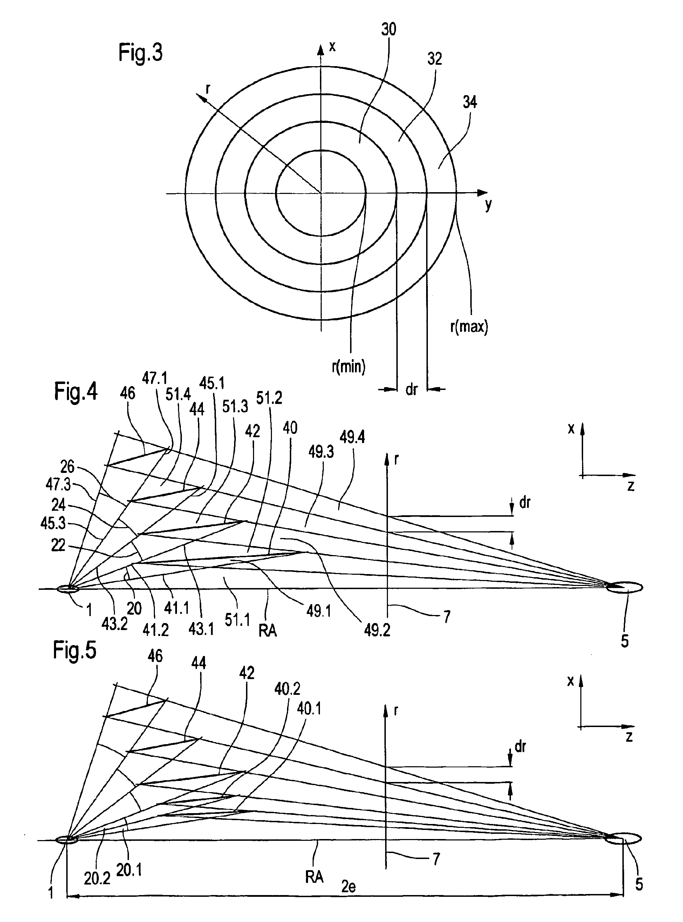

Die Ringelemente 30, 32, 34 werden beispielsweise so gewählt, daß gleich große Abstände $dr_i = dr = $ konstant zwischen den Randstrahlen der Ringelemente erzielt werden. In Figur 3 ist die Ausleuchtung in der Ebene 7 mit Ringelementen 30, 32, 34 gezeigt.

Für ein Ringelement mit weitgehend gleichmäßiger Bestrahlungsstärke in Ebene 7 gilt für den Strahlungsfluß:

$$(2.6) \qquad \Phi_i' = 2\pi \int_{r=r_i}^{r_{i+1}} Er\,dr \approx \pi E \cdot \left(r_{i+1}^2 - r_i^2\right)$$

wobei

$\phi_i'$:      Strahlungsfluß durch das i-te Ringsegment in der auszuleuchtenden Ebene 7

Unter Berücksichtigung des Reflexionsverlustes an der i-ten Kollektorschale $R'(\alpha)$ kann damit die Breite $d\alpha_i$ des i-ten Ringaperturelementes und der radialen Ausdehnung $dr_i$ des i-ten Ringsegmentes bestimmt werden. Beispielsweise kann die radiale Ausdehnung $dr$ konstant gewählt werden. Mit

$$(2.7) \quad \Phi_i' = R'(\alpha_i)\Phi_i$$

und der Forderung nach weitgehend gleichmäßiger Bestrahlungsstärke E

$$(2.8) \quad E = \frac{\Phi_i'}{\pi \cdot \left( r_{i+1}^2 - r_i^2 \right)} = const.$$

folgt nach Einsetzen von Gleichung (2.4b) und Auflösen nach $\alpha_{i+1}$

$$(2.9) \quad \alpha_{i+1} = \arccos\left[ \cos\alpha_i - E \frac{\left( r_{i+1}^2 - r_i^2 \right)}{2 I(\alpha_i) \cdot R'(\alpha_i)} \right]$$

wobei

E: weitgehend gleichmäßige Bestrahlungsstärke in der auszuleuchtenden Ebene 7

$r_i$ : innerer Abstand des i-ten Ringelementes in der auszuleuchtenden Ebene 7

$r_{i+1}$ : äußerer Abstand des i-ten Ringelementes in der auszuleuchtenden Ebene 7

$\alpha_i$ : innerer Winkel des i-ten Ringaperturelementes

$\alpha_{i+1}$ : äußerer Winkel des i-ten Ringaperturelementes

Sind über Gleichung (2.5) die Ringelemente in Ebene 7 gewählt, so können die Winkel der Ringaperturelemente nach Gleichung (2.9) bestimmt werden. Damit sind die Randstrahlen der Ringelemente bzw. der Ringaperturelemente festgelegt.

Über die Kreuzungspunkte ausgewählter Strahlen sind dann die jeweiligen Ellipsenschalen des Kollektors 3 festgelegt. Bei einem virtuellem Zwischenbild sind diese hyperbelförmig, bei einem Quellenbild im Unendlichen parabelförmig. Hierzu wird ein repräsentativer Strahl in jeweils einem Ringaperturelement 20, 22, 24 gewählt.

Für eine ellipsoidförmige respektive hyperbel- oder parabelförmige Schale genügen also die Angabe von Objekt- und Bildpunkt, hier Quelle 1 und Quellbild 5, und nur einem weiteren Punkt. Vorliegend sind aber zwei Punkte, nämlich ein Anfangspunkt und ein Endpunkt der Kollektorschale gegeben, d. h. das Problem ist überbestimmt. Da jedoch die Abbildungsqualität für die Quellenabbildung für Beleuchtungszwecke in der Regel weitgehend vernachlässigt werden kann, kann man beispielsweise den Ellipsen respektive Hyperbeln oder Parabeln einen konischen Anteil in Form eines Keils oder Kegelstumpfes hinzufügen, was einer leichten Defokussierung entspricht, die nicht ins Gewicht fällt. Alternativ nimmt man eine geringfügige Abschattung in Kauf, da die auftretenden Lücken sehr gering gewählt werden können. Die Größe der Lücken kann über das Layout und insbesondere die Anzahl der Schalen minimiert werden. Die Lücken wählt man zum Beispiel so, daß sie vorne, d.h. in der aufgenommenen Leistung von der Quelle, auftreten und nicht hinten, in der auszuleuchtenden Fläche.

Es ist auch möglich, den Kollektor nur aus Kegelstümpfen aufzubauen, insbesondere dann, wenn der Kollektor viele Schalen umfaßt. Dies ist unter Fertigungsaspekten vorteilhaft.

Unter Vernachlässigung der Abschattungen ist dann gewährleistet, daß sich ein jeweils gleicher Strahlungsfluß sowohl durch die Winkelsegmente bzw. Ringaperturelemente 20 bis 24 als auch durch die Flächensegmente bzw. Ringelemente 30 bis 34 ergibt.

Prinzipiell ist auch möglich, die Reflexionsverluste Winkel- und damit segmentabhängig durch geeignetes Vorhalten in den Winkelinkrementen ᵢ zu kompensieren, wobei, da man die Fläche 7 gemäß der Erfindung weitgehend homogen ausleuchten möchte, die Ringapertursegmente, welche zu Ringsegmenten mit gleichen Inkrementen zugeordnet sind, nicht gleich groß sind. Alternativ können auch die Höheninkremente dr der Ringelemente ungleich groß gewählt werden.

In Figur 4 ist ein genesteter Kollektor 3 gezeigt, bestehend aus Ellipsoidsegmenten, welche rotationssymmetrisch um die z-Achse angeordnet sind, der eine weitgehend gleichverteilte Ausleuchtung der Ebene 7 gewährleistet. Aufgrund der Rotationssymmetrie um die z-Achse ist nur eine Hälfte des Kollektors 3 im Schnitt dargestellt. Der in Figur 4 dargestellte Kollektor umfasst vier Schalen 40, 42, 44 und 46.

Die Schalen 40, 42, 44, 46, sind etwa äquidistant von der z-Achse, was den maximalen Schalendurchmesser betrifft, welcher etwa proportional zur Schalennummer i ist, angeordnet, d.h. der Abstand zweier benachbarter Schalen ist etwa gleich.

Jeder Spiegelschale 40, 42, 44, 46 ist ein innerer Randstrahl 41.1, 43.1, 45.1, 47.1 zugeordnet, der durch den Endpunkt der optischen Fläche der Spiegelschale gegeben ist sowie ein äußerer Randstrahl 41.2, 43.2, 45.2, 47.2 , der durch den Anfangspunkt der optischen Fläche der Spiegelschale bestimmt ist. Wie in Figur 4 deutlich zu erkennen, definieren der innere und der äußere Randstrahl einer jeden Spiegelschale ein dieser Spiegelschale zugeordnetes Strahlbüschel 49.1, 49.2, 49.3, 49.4, das an den optischen Flächen der Spiegelschalen 40, 42,44, 46 in Richtung des Quellbildes reflektiert wird. Unter optischer Fläche(n) einer Spiegelschale versteht man in vorliegender Anmeldung die Fläche(n) der Spiegelschale, die das von der Lichtquelle 1 her einfallende Strahlbüschel aufnimmt und in Richtung des Bildes 5 der Lichtquelle reflektiert. Das einfallende Strahlbüschel und das an der optischen Flächen der Spiegelschale reflektierte Strahlbüschel definieren zwischen zwei benachbarten Spiegelschalen einen vom Licht genutzten Bereich. Deutlich zu erkennen ist auch, daß auf der der optischen Fläche abgewandten Seite der benachbarten Spiegelschale ein ungenutzter Bereich 51.1, 51.2, 51.3, 51.4 zur Verfügung gestellt wird, in dem Komponenten beispielsweise ohne optische Wirkung, wie beispielsweise Kühleinrichtungen, angeordnet werden können. Der Vorteil einer Anordnung in diesen ungenutzten Bereichen, beispielsweise von Kühleinrichtungen, ist, daß sie eine Kühlung ohne zusätzlichen Lichtverlust ermöglichen.

In Figur 4 ist des weiteren die Lichtquelle 1, die auszuleuchtende Ebene 7 sowie das Quellbild 5 gezeigt.

Die Bezugsziffern der anderen Elemente entsprechen denen in den vorangegangenen Figuren.

Alternativ ist eine Anordnung möglich, bei der die Länge der Schalen reduziert wird, wie in Figur 5 gezeigt. Beispielsweise kann das innerste Winkelsegment bzw. Ringapturelement 20 in zwei Winkelsegmente bzw. Ringaperturelemente 20.1 und 20.2 geteilt werden. Entsprechend wird auch das zugeordnete innerste Ringelement 30 in der Fläche 7 in zwei Ringelemente 30.1, 30.2 geteilt. Es ergeben sich dann zwei Schalen 40.1, 40.2 für die beiden inneren Segmente, welche kürzer als eine Schale 40 sind, wie aus Figur 5 deutlich hervorgeht. Gleiche Bauteile wie in den vorangegangenen Figuren sind mit denselben Bezugsziffern belegt.

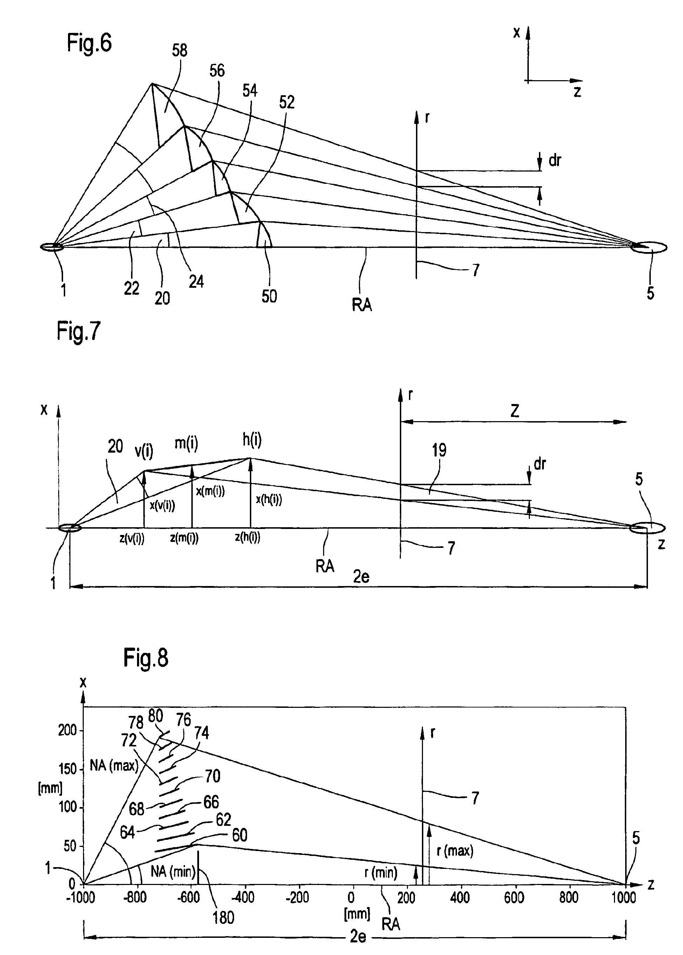

Auch für refraktive Systeme kann man sich ähnliche Anordnung vorstellen. Bei refraktiven Systemen werden die genesteten Spiegelschalen 40, 42, 44, 46 durch ringförmige Off-Axis Segmente von Linsen 50, 52, 54, 56 ersetzt wie in Figur 6 gezeigt.

Figur 6 zeigt schematisch eine Anordnung von ringförmigen off-axis Segmenten von Linsen, welche eine gleichverteilte Ausleuchtung der Ebene 7 für eine bestimmte Abstrahlcharakteristik der Quelle ergibt. Das um die z-Achse rotationssymmetrische System ist im Schnitt nur zur Hälfte schematisch dargestellt. Ungleich große Winkelelemente werden auf gleich große Höhensegmente abgelenkt und somit eine homogene Ausleuchtung auch bei anisotroper Quellabstrahlung zu erreichen.

Genestete, reflektive Kollektoren weisen notwendigerweise eine zentrale Abschattung auf, d. h. unterhalb einem bestimmten Aperturwinkel $NA_{min}$ kann die Strahlung der Quelle nicht aufgenommen werden. Diese Strahlung muß daher mit einer Blende abgeblockt werden, damit sie nicht in das nachfolgende Beleuchtungssystem gelangen kann. Die Blende kann z. B. im Bereich des Kollektors angebracht werden.

Nachfolgend soll die Erfindung anhand eines Ausführungsbeispiels näher beschrieben werden.

Ausgegangen wird von einer Punkt-zu-Punkt Abbildung mit reellem Quellenbild bei isotroper Quelle mit einer Ellipsenschar entsprechend der Erfindung, wobei die Abstände benachbarter Spiegelschalen etwa gleich gewählt werden.

Eine Ellipse ist definiert entsprechend der Gleichung

$$(3.1) \qquad \frac{z^2}{\alpha^2} + \frac{x^2}{b^2} = 1$$

wobei

$$(3.2) \qquad e = \sqrt{a^2 - b^2}$$

ist.

In Figur 7 ist beispielhaft das i-te Ellipsensegmenten dargestellt. Da dieses rotationssymmetrisch um z-Achse ist, ist nur eine Hälfte im Schnitt gezeigt.

In Figur 7 sind für eine Spiegelschale die für die Berechnung gemäß Tabelle 1 verwandten Größen dargestellt. Für gleiche Bauteile wie in den vorangegangenen Figuren werden dieselben Bezugsziffern verwandelt. Es bezeichnet

| | |
|---|---|
| v(i) | den i-ten Anfangspunkt der i-ten Spiegelschalen |
| x(v(i)) | die x-Koordinate des i-ten Anfangspunktes |
| z(v(i)) | die z-Koordinate des i-ten Anfangspunktes, d. h. den Anfangspunkt in Bezug auf die Rotationsachse RA |
| h(i) | den i-ten Endpunkt der i-ten Spiegelschale |
| x(h(i)) | die x-Koordinate des i-ten Endpunktes |
| z(h(i)) | die z-Koordinate des i-ten Endpunktes, d. h. den Endpunkt in Bezug auf die Rotationsachse RA |
| m(i) | den Mittelwert von Anfangs- und Endpunkt der i-ten Schale |
| x(m(i)) | die x-Koordinate des Mittelwertes |
| z(m(i)) | die z-Koordinate des Mittelwertes, d. h. den Mittelwert von Anfangs- und Endpunkt der i-ten Schale in Bezug auf die Rotationsachse RA |
| a, b | Parameter der Ellipse |
| r(i) | Abstand des i-ten Ringelementes der i-ten Schale in der auszuleuchtenden Ebene von der Rotationsachse RA |
| NA(i) | Sinus des Öffnungswinkels des inneren Randstrahls des i-ten Ringaperturelementes der i-ten Schale |

Figur 8 zeigt für das mit den oben definierten Parametern berechnete Ausführungsbeispiel die sich ergebende Ellipsenschar der Schalen 60, 62, 64, 66, 68, 70, 72, 74, 76, 80. Im vorliegenden Ausführungsbeispiel wurden sowohl gleich große Winkelinkremente $d\alpha$, als auch gleich große Höheninkremente dr gewählt. Dies ist bei isotropen Quellen und kleineren Aperturen möglich, insbesondere falls die Bestrahlungsstärke nur annähernd gleich sein soll. Die Daten sind in Tabelle 2 angegeben. Alle Längen in Tabelle 2 sind in mm angegeben. Sämtliche Einfallswinkel relative zur Flächentangente sind unter 19°. Der Einfallswinkel relativ zur Flächentangente des Maximalstrahls beim Ausführungsbeispiel gemäß Figur 8 beträgt 18,54°.

Als Startwerte wurden gewählt:

Abstand zwischen Ebene 7 und Quellbild 5:

$$z = 900 \text{ mm}$$

Halber Brennpunktsabstand:

$$e = 1000 \text{ mm}$$

Höheninkrement auf Fläche 7:

$$dr = 7,5 \text{ mm}$$

Mittenabschattung in Fläche 7:

$$r_{min} \sim 22,5 \text{ mm} \ (NA'_{min} \sim 0,025)$$

minimale Apertur $NA_{min}$ bei Quelle 1:

$$NA_{min} = 0,12$$

Maximal aufgenommene Apertur $NA_{max}$:

$$NA_{max} < 0,55 \text{ entsprechend } 33°$$

.

Winkelinkrement an Quelle 1:

$$d\alpha_i = 2{,}4° = \text{const.}$$

Tabelle 2: Parameter der Ellipsenschar

| i | Bezug sziffer | r(i) | NA(i) | a | b | x(h(i)) | z(h(i)) | x(v(i)) | z(v(i)) |
|---|---|---|---|---|---|---|---|---|---|
| 1 | 60 | 22,507 | 0,120 | 1002,009 | 63,422 | 52,266 | -567,601 | 43,117 | -734.837 |
| 2 | 62 | 30,007 | 0,161 | 1003,391 | 82,423 | 66,429 | -593,993 | 57,195 | -722,489 |
| 3 | 64 | 37,507 | 0,203 | 1005,130 | 101,423 | 80,551 | -610,765 | 71,258 | -715,251 |
| 4 | 66 | 45,007 | 0,243 | 1007,231 | 120,475 | 94,679 | -622,848 | 85,334 | -710,997 |
| 5 | 68 | 52,507 | 0,284 | 1009,699 | 139,612 | 108,838 | -632,382 | 99,443 | -708,705 |
| 6 | 70 | 60,007 | 0,324 | 1012,540 | 158,863 | 123,046 | -640,449 | 113,597 | -707,824 |
| 7 | 72 | 67,507 | 0,363 | 1015,762 | 178,250 | 137,317 | -647,655 | 127,810 | -708,034 |
| 8 | 74 | 75,007 | 0,402 | 1019,374 | 197,798 | 151,664 | -654,371 | 142,092 | -709,139 |
| 9 | 76 | 82,507 | 0,440 | 1023,386 | 217,529 | 166,097 | -660,836 | 156,455 | -711,012 |
| 10 | 78 | 90,007 | 0,477 | 1027,808 | 237,466 | 180,628 | -667,215 | 170,909 | -713,571 |
| 11 | 80 | 97,507 | 0,513 | 1032,654 | 257,632 | 195,269 | -673,626 | 185,464 | -716,763 |

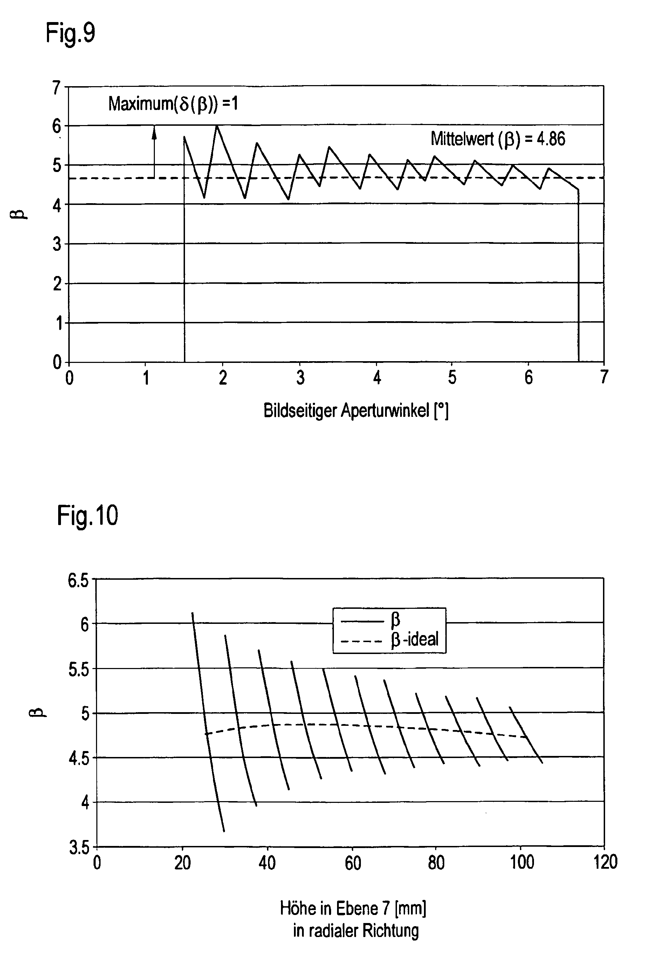

In Figur 9 ist der Abbildungsmaßstab β des Ausführungsbeispieles gemäß Figur 8 und Tabelle 2 als Maß für die Homogenität der Ausleuchtung als Funktion vom bildseitigen Aperturwinkel aufgetragen. Über den Winkel muß der Abbildungsmaßstab β nicht konstant sein, aber über den Maximalradius $r_{max}$ in Ebene 7 muß sich ein bestimmter Abbildungsmaßstab einstellen.

In Figur 10 ist der ideale Abbildungsmaßstab β-ideal und der reale Abbildungsmaßstab β durch diskretisierte Lösung der Kollimationsaufgabe dargestellt in Abhängigkeit von dem Radius r in der Ebene 7. Die Abweichung vom idealen Abbildungsmaßstab kann verringert werden durch eine Vergrößerung der Anzahl der Schalen, beispielsweise durch eine Aufspaltung der inneren Schalen in z. B. jeweils zwei Schalen wie in Figur 5 gezeigt. Damit kann eine noch bessere Homogenisierung der Ausleuchtung in Fläche 7 erreicht werden.

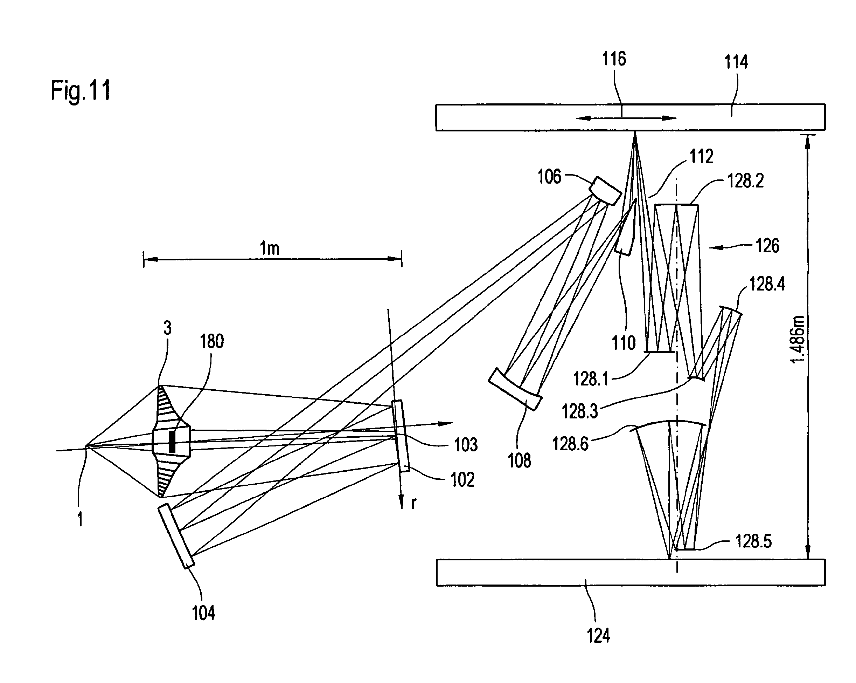

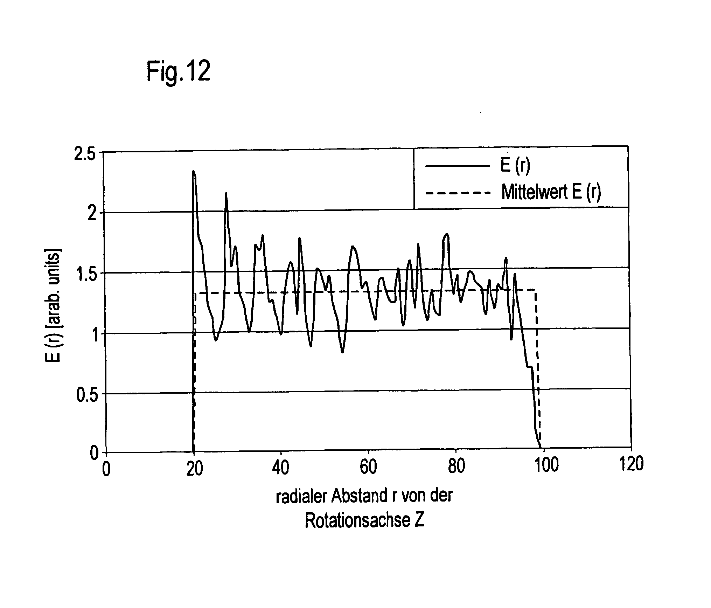

In Figur 11 ist in einer Prinzipansicht eine Projektionsbelichtungsanlage für die Herstellung von beispielsweise mikroelektronischen Bauteilen, bei der die Erfindung zur Anwendung kommen kann, gezeigt. Die Projektionsbelichtungsanlage umfaßt eine Lichtquelle oder ein Zwischenbild einer Lichtquelle 1. Das von der Lichtquelle 1 ausgesandte Licht, von dem nur vier repräsentative Strahlen gezeichnet sind, wird von einem erfindungsgemäßen genesteten Kollektor 3 gesammelt und auf einen Spiegel 102 mit einer Vielzahl von ersten Rasterelementen, sogenannten Feldwaben gelenkt. Im vorliegenden Fall sind die ersten Rasterelemente plan. Der Spiegel 102 wird auch als Feldwabenspiegel bezeichnet. Die Ausleuchtung in der Ebene 103 in der der Feldwabenspiegel angeordnet ist, ist in einem vorgegebenen annularen Bereich weitgehend homogen wie in Figur 12 gezeigt. Die Ebene 103 steht nicht genau senkrecht zur optischen Achse des Kollektors und entspricht damit nicht exakt der homogen auszuleuchtenden Ebene 7 aus Figur 1. Geringe Neigungswinkel ändern jedoch an der Ableitung nichts und führen nur zu geringen Verzerrungen der Ausleuchtung und damit zu einer vernachläßigbaren Abweichung von der Homogenität, wie sie in einer Ebene senkrecht zur optischen Achse des Kollektors vorliegen würde. Das Beleuchtungs-system ist eine doppelt facettiertes Beleuchtungssystem wie in der US 6,198,793 B1 offenbart, deren Inhalt vollumfänglich in die vorliegende Anmeldung mit aufgenommen wird. Das System umfaßt somit ein zweites optisches Element mit Rasterelementen 104, die als Pupillenwaben bezeichnet werden. Die optischen Elemente 106, 108 und 110 dienen im wesentlichen dazu, das Feld in der Objektebene 114 zu formen. Das Retikel in der Objektebene ist eine Reflexionsmaske. Das Retikel ist in dem als Scanning-System ausgelegten EUV-Projektionssystem in die eingezeichnete Richtung 116 verfahrbar. Die Austrittspupille des Beleuch-tungssystems wird weitgehend homogen ausgeleuchtet. Die Austrittspupille fällt mit der Eintrittspupille eines nachfolgenden Projektionsobjektives zusammen. Die Eintrittspupille des Projektionsobjektives ist nicht dargestellt. Sie befindet sich an der Stelle des Schnittpunktes des vom Retikel reflektierten Hauptstrahles mit der optischen Achse des Projektionsobjektives.

Ein Projektionsobjektiv 126 beispielsweise mit sechs Spiegeln 128.1, 128.2, 128.3, 128.4, 128.5, 128.6 gemäß der US-Patentanmeldung 09/503640 bildet das Retikel auf das zu belichtende Objekt 124 ab.

Figur 12 zeigt die Ausleuchtungsverteilung in der Ebene des ersten optischen Elementes mit ersten Rasterelementen und den Mittelwert der Ausleuchtung. Die Bestrahlungsstärke E (r) ist in Abhängigkeit vom radialen Abstand r von der Rotationsachse z des genesteten Kollektors gezeigt. Deutlich zu erkennen die nur diskrete Erfüllung der homogenisierten Ausleuchtung.

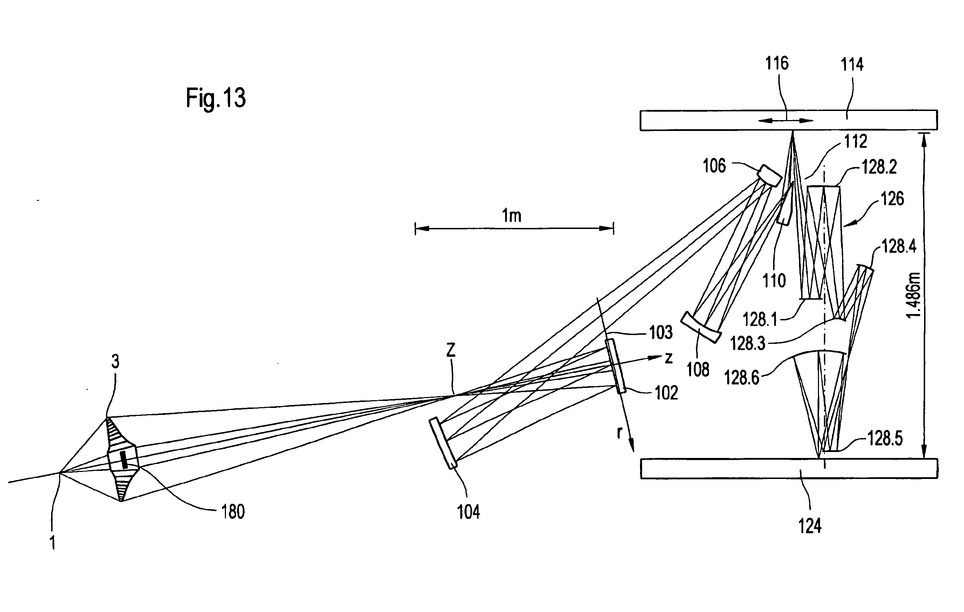

In Figur 13 ist eine Prinzipskizze einer EUV-Projektionsbelichtungsanlage gezeigt, die sich von der in Figur 11 dargestellten Anlage lediglich dadurch unterscheidet, daß die Lichtquelle 1 in ein Zwischenbild Z abgebildet wird. Zusätzlich weisen die ersten Rasterelemente jetzt eine sammelnde Wirkung auf. Das Zwischenbild Z der Lichtquelle 1 wird zwischen Kollektor 3 und dem ersten facettierten Spiegel 102 ausgebildet. Sämtliche anderen Bauelemente sind identisch mit den Bauelementen gemäß Figur 11 und tragen daher dieselben Bezugzeichen.

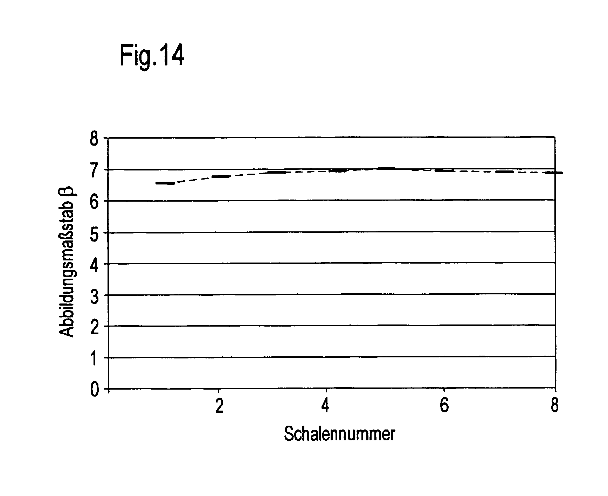

In den nachfolgenden Figuren 14 bis 21 werden erfindungsgemäße genestete Kollektoren beschrieben, die als Woltersysteme ausgeführt sind.

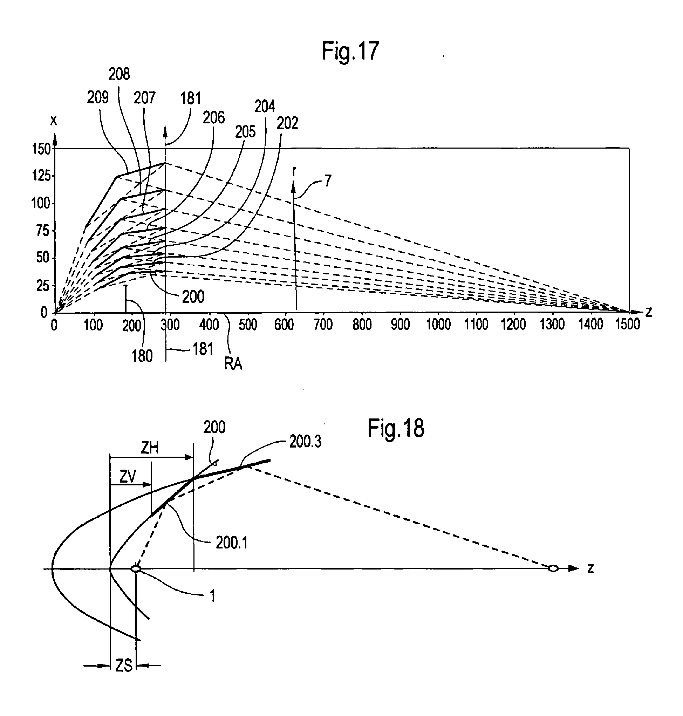

Ein Woltersystem, bestehend vorzugsweise aus einer Kombination eines Hyperboloids und eines Ellipsoids für die reelle Abbildung der Lichtquelle 1 in ein Zwischenbild Z der Quelle, aber auch Hyperboloid-Paraboloid für eine Abbildung nach unendlich, zeichnet sich durch weitgehende Erfüllung der Sinusbedingung aus, d.h. die Vergrößerung bzw. der Abbildungsmaßstab einer Kombination von Hyperboloid und Ellipsoid ist über einen großen Aperturbereich weitgehend konstant. Wie Figur 9 zeigt, variiert bei einem Kollektor zur homogenisierten Ausleuchtung mit nur einfachen Ellisoid-Schalen der Abbildungsmaßstab β innerhalb der Schale sehr stark. Bei einem Woltersystem ist der Abbildungsmaßstab β hingegen innerhalb der Schale weitgehend konstant. Dies ist in Figur 14 für ein 8-schaliges genestetes System gemäß Figur 17 gezeigt, bei dem jede einzelne der genesteten Spiegelschalen ein Woltersystem ist, mit einem ersten ringförmigen Segment mit einer ersten optischen Fläche, die ein Ausschnitt eines Hyperboloides ist und einem zweiten ringförmigen Segment mit einer zweiten optischen Fläche, die ein Ausschnitt eines Ellipsoid ist. Woltersysteme haben also im Gegensatz zu den Systemen mit einfachen Ellipsoidschalen pro Schale zwei optische Flächen, eine erste und eine zweite optische Fläche. Diese können auch mechanisch voneinander getrennt sein.

Da, wie in Figur 14 gezeigt, eine Schale eines Woltersystems nahezu einen konstanten Abbildungsmaßstab β aufweist, ist es zur Erreichung einer ideal homogenisierten Ausleuchtung einer Ebene erforderlich, daß in der objektseitigen Apertur Lücken auftreten. Dies gilt insbesondere auch deswegen, weil unter streifendem Einfall an den Schalen, die den größten Abstand zur Rotationsachse aufweisen, die Reflektivität geringer ist als Schalen, die den geringsten Abstand zur Rotationsachse aufweisen. Als Spiegelmaterialien kommen vorzugsweise Molybdän, Niob, Ruthenium, Rhodium, Palladium oder Gold in Frage. Das muß durch einen zunehmenden Abbildungsmaßstab kompensiert werden. Zur homogenen Ausleuchtung muß dann von Schale zu Schale der Abbildungsmaßstab geändert werden. Will man dabei eine lückenlose Füllung der Apertur nach dem Kollektor bzw. eine lückenlose Ausleuchtung der Fläche 7 hinter dem genesteten Kollektor erreichen, so treten in der objektseitigen Apertur Lücken auf. Dies ist bei einem Kollektor mit zum Beispiel ellipsoidförmigen Schalen, wie in den Figuren 1 bis 13 beschrieben, nicht der Fall, da dort der Abbildungsmaßstab über die Schale variiert und damit neben der homogenisierten, lückenlosen Ausleuchtung einer Ebene 7 zusätzlich auch eine lückenlose objektseitige Apertur erreicht werden kann.

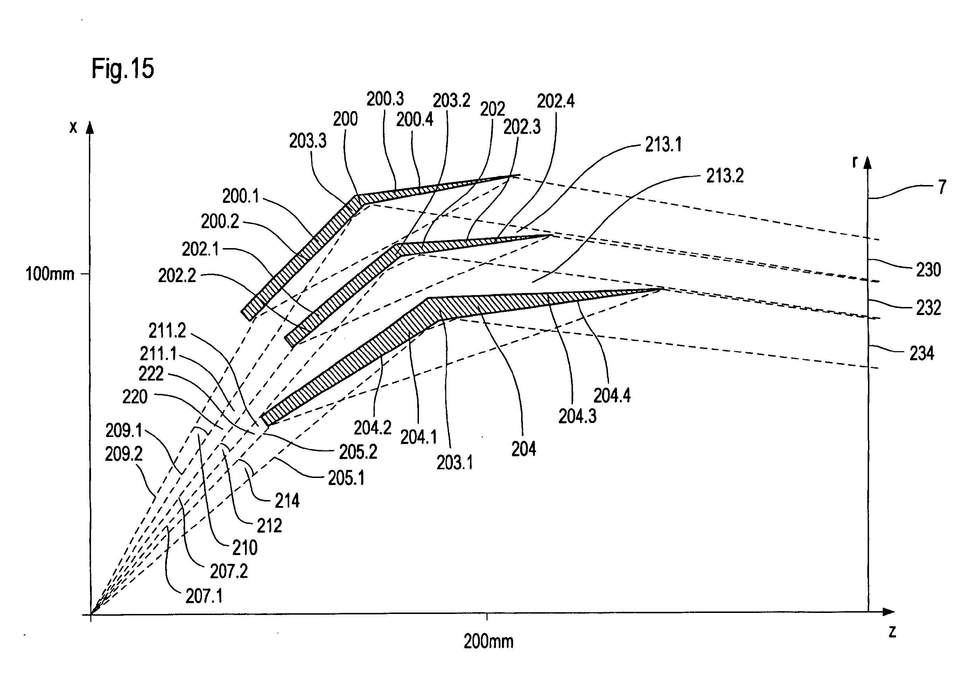

In Figur 15 sind von einem genesteten Kollektor gemäß der Erfindung exemplarisch drei Schalen gezeigt, wobei jede Spiegelschale 200, 202 und 204 ein Woltersystem mit einem ersten ringförmigen Segment 200.1, 202.1, 204.1 mit einer ersten optischen Fläche 200.2, 202.2, 204.2 und einem zweiten ringförmigen Segment 200.3, 202.3, 204.3 mit einer zweiten optischen Fläche 200.4, 202.4, 204.4 aufweist. Die einzelnen Schalen 200, 202, 204 sind rotationssymmetrisch um die z-Achse angeordnet. Der Abbildungsmaßstab β der innersten Schale 204 beträgt 6.7, der der zweiten Schale 202 7.0 und der der äußersten Schale 200 7.5. Wie man aus Figur 15 erkennt, grenzen die Ringaperturelemente 210, 212, 214, die den jeweiligen Spiegelschalen 200, 202 und 204 zugeordnet sind, nicht aneinander, d.h. die objektseitige Apertur des in Figur 15 gezeigten Kollektors weist zwischen den einzelnen Ringaperturelementen 210, 212, 214 Lücken 220, 222, 224 auf. Die der jeweiligen Spiegelschale 200, 202, 204 zugeordneten Ringelemente 230, 232, 234 in der Ebene 7 schließen zur Erzielung einer homogenen Ausleuchtung eines Bereiches der Ebene 7 weitgehend kontinuierlich aneinander an.

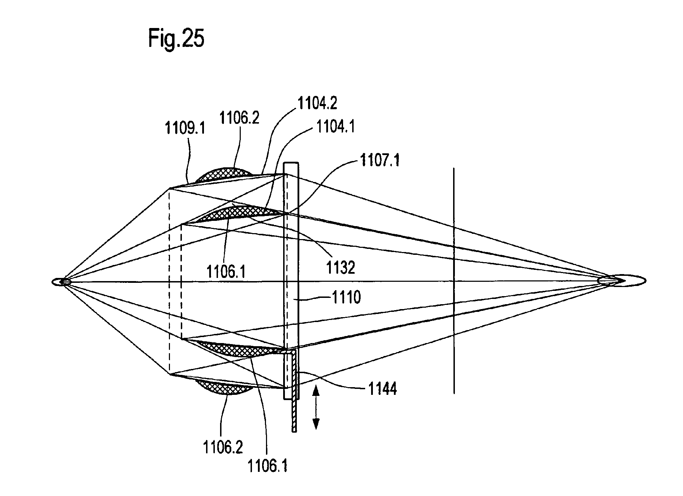

Besonders bevorzugt sind im Bereich der Lücken 220, 222 der Ringaperturelemente auf der Rückseite der Spiegelschale 200, 202; 204 Kühleinrichtungen 203.1, 203.2, 203.3 angeordnet. Die Kühleinrichtungen sind bevorzugt Kühlkanäle, die von einem Kühlmittel durchspült werden können. Die Kühleinrichtungen 203.1, 203.2, 203.3 erstrecken sich auf der Rückseite der jeweiligen Schalen weitgehend über deren gesamte Länge in Richtung der Rotationsachse. Eine Ausführungsform mit zusätzlichen Komponenten, die in einem nicht genutzten Bereich des Kollektors zwischen zwei Spiegelschalen angeordnet sind, ist nochmals näher in Figur 25 gezeigt und beschrieben.

Jeder Schale 200, 202, 204 ist je ein innerer Randstrahl 205.1, 207.1, 209.1, der durch den Endpunkt in der Meridonalebene der ersten optischen Fläche des ersten Segmentes der Spiegelschale definiert ist, und ein äußerer Randstrahl 205.2, 207.2, 209.2, der durch den Anfangspunkt in der Meridonalebene der ersten optischen Fläche des ersten Segmentes der Spiegelschale definiert ist, zugeordnet. Der innere und der äußere Randstrahl bestimmen das von der Schale aufgenommene und zum Quellbild innerhalb zweier benachbarter Schalen weitergeleitete Strahlbüschel.

Der Bereich, der zwischen zwei Kollektorschalen nicht von einem Strahlbüschel 211.1, 211.2, durchlaufen wird, wird wie schon beim einschaligen Kollektor gemäß Figur 4 als ungenutzter Bereich 213.1, 213.2 bezeichnet. Wie aus Figur 15 deutlich zu erkennen, sind die im Bereich der Lücken der Ringapterelemente auf der Rückseite der Spiegelschalen angeordneten Kühleinrichtungen im ungenutzten Bereich zwischen zwei Spiegelschalen angeordnet.

Bei der in Figur 15 dargestellten Ausführungsform schließen auch die erste optische Fläche 200.2, 202.2, 204.2 und die zweite optische Fläche 200.4, 202.4 und 204.4 ohne Lücke direkt aneinander an.

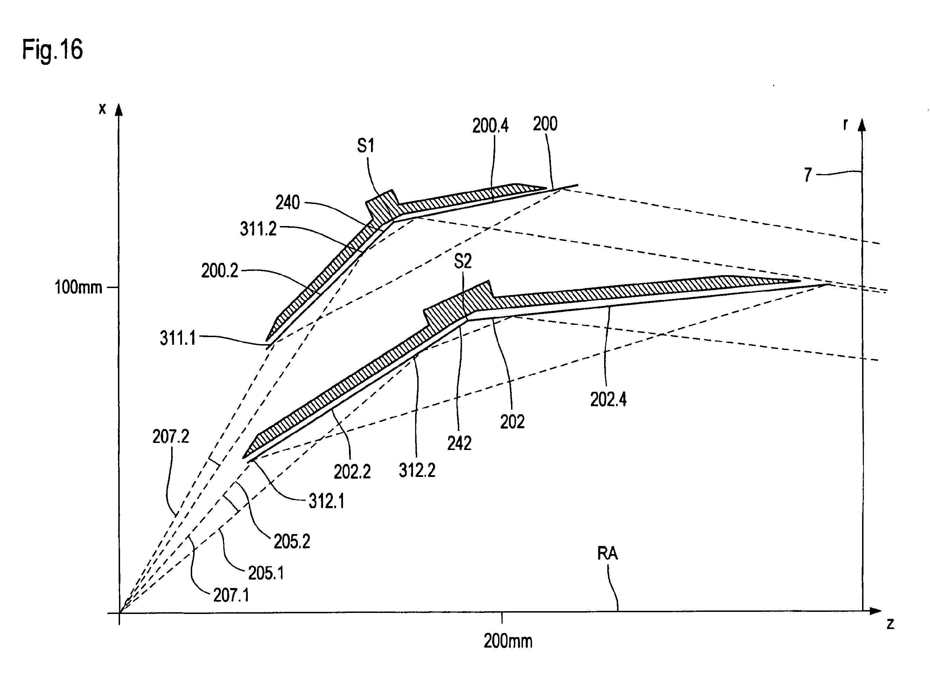

In Figur 16 ist ein weiteres Ausführungsbeispiel der Erfindung, wobei exemplarisch nur zwei Spiegelschalen 200, 202, die als Woltersystem ausgelegt sind, dargestellt sind. Gleiche Bauteile wie in Figur 15 sind mit denselben Bezugsziffern belegt. Bei der Ausführungsform in Figur 16 schließen die erste optische Fläche 200.2, 202.2 und die zweite optische Fläche 200.4, 202.4 nicht direkt aneinander an. Zwischen den optischen Flächen gibt es je eine Lücke bzw. einen ungenutzten Bereich 240, 242. Im ungenutzten Bereich werden im vorliegenden Ausführungsbeispiel die Spiegelschalen jedoch bis zum Schnittpunkt S1, S2 von ersten und zweiten Segment 200.1, 202.1, 200.3, 202.3 der jeweiligen Spiegelschale fortgeführt. Beide erste optische Flächen 200.2, 202.2 auf den ersten Spiegelsegmenten werden in der Meridonalebene durch Anfangspunkte 311.1, 312.1 und Endpunkte 311.2 und 312.2 begrenzen, wobei die Meridonalebene im vorliegenden Fall durch jede Ebene gegeben ist, welche die optische Achse oder Rotationsachse enthält. Anfangs- und Endpunkte 311.1, 312.1, 311.2, 312.2 der optischen Flächen definieren Randstrahlen 205.1, 205.2, 207.1 und 207.2 welche um die Rotationsachse rotiert ein Lichtbüschel definieren, das den Kollektor hindurchgereicht wird, d.h. den Kollektor von der Objektseite zur Bildseite durchläuft. Das durch den Kollektor hindurchgereichte Lichtbüschel wiederum definiert den genutzten Bereich des Kollektors.

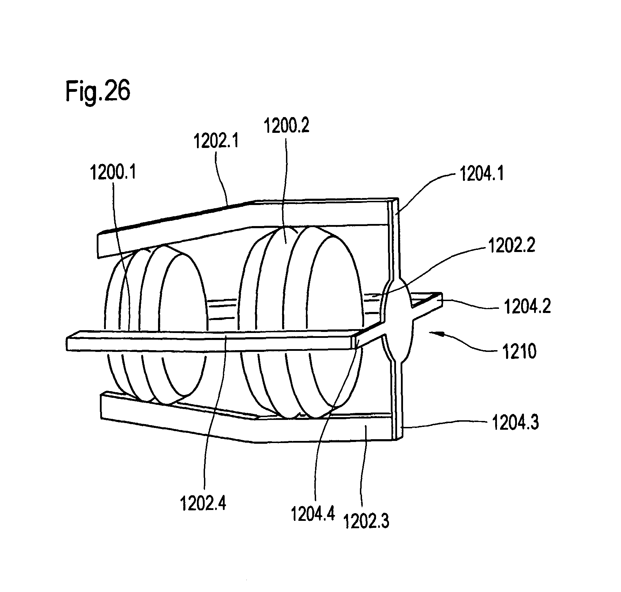

Wie in Figur 16 gezeigt, kann im Bereich der Lücke 240, 242 eine Kühleinrichtung, beispielsweise ein um in den vollen Umfang der Spiegelschale umlaufendes Kühlschild angeordnet sein. Die Kühlschilde können durch in Richtung der Rotationsachse verlaufende Stege ,wie in Figur 26 gezeigt ,mechanisch gehalten werden. Für einen guten thermischen Kontakt sind die Stege mit den umlaufenden Kühlschilde beispielsweise verlötet. Die in Richtung der Rotationsachse verlaufenden Halteelemente für die Kühlschilde können an den die Spiegelschalen haltenden Haltestrukturen, beispielsweise Speichenrädem, befestigt sein. Die Speichenräder und Haltestrukturen sind in der vorliegenden Figur 16 nicht dargestellt.

Ein Design mit Lücken bzw. ungenutzten Bereichen, wie in Figur 16 gezeigt, ist vorteilhaft bei ausgedehnten Lichtquellen.

Bei der Auslegung des Kollektors ist stets eine Abwägung zwischen Kollektionseffienz und Homogenität der Ausleuchtung vorzunehmen. Will man in der auszuleuchtenden Fläche 7 lediglich eine Homogenität von $\pm$ 15 % erreichen, so kann hierfür ein 8-schaliger Kollektor, wie in Figur 17 gezeigt, eingesetzt werden. Hierbei bezeichnen 200, 202, 204, 205, 206, 207, 208, 209 die jeweiligen Spiegelschalen mit je zwei Spiegelsegmenten, wobei jede Schale ein Woltersystem darstellt.

Der Kollektor aus Figur 17 hat einen Abstand zwischen Quelle 1 und Zwischenbild der Quelle Z von 1500 mm, eine objektseitige Apertur von ~ 0.72 und eine bildseitige Apertur von ~ 0.115. Sämtliche Einfallswinkel relativ zur Flächentangente sind $\leq$ 13. Der Einfallswinkel relativ zur Flächentangente des Maximalstrahls beim Ausführungsbeispiel gemäß Figur 17 beträgt 11,9.

In Figur 17 ist des weiteren eine im Inneren der innersten Spiegelschale angeordnete Blende 180 gezeigt. Genestete, reflektive Kollektoren weisen wegen der endlichen Größe der Spiegelschalen notwendigerweise eine zentrale Abschattung auf, d. h. unterhalb eines bestimmten Aperturwinkels $NA_{min}$ kann die Strahlung der Quelle nicht aufgenommen werden. Die Blende 180 verhindert, daß direkt durch die zentrale Schale gelangendes Licht nicht als Falschicht in das nachfolgende Beleuchtungssystem gelangt.

Die Blende 180 ist beispielsweise 78 mm hinter der Quelle angeordnet und hat einen Durchmesser von 30.3 mm entsprechend einer Aperturobskuration von $NA_{obs}$ ~0.19. die bildseitige Aperturobskuration beträgt entsprechend $NA'_{obs}$ ~ 0.0277.

In Figur 18 sind beispielhaft für die Spiegelschale 200, 202, 204, 205, 206, 207, 208, 209 des Kollektors gemäß Figur 17 die charakteristischen Koordinaten eines Woltersystems, umfassend zwei Segmente, beispielsweise das erste Segment 200.1 und das zweite Segment 200.3 der ersten Spiegelschale 200 dargestellt. Es bezeichnet ZS die z-Position des Flächenscheitels bezogen auf die Position der Lichtquelle 1, ZV und ZH die Anfangs- und Endposition des ersten Segmentes 200.1, das ein Hyperboloid ist, bezogen auf die Position des Flächenscheitels ZS. Für das zweite Segment 200.3 der Spiegelschale, das ein Ellipsoid ist, werden die Bezugszeichen ZS, ZH und ZV in analoger Art und Weise verwandt.

Mit den Krümmungsradien R und der konischen Konstanten K des jeweiligen Spiegelsegmentes sowie den angegebenen Definitionen ergeben sich die Designdaten des Kollektors gemäß Figur 17 aus nachfolgender Tabelle 3. Als Beschichtung der Spiegelschalen wurde Ruthenium gewählt.

Tabelle 3: Designdaten des Kollektors gemäß Figur 17

| | Hyperboloid | | | | |
|---|---|---|---|---|---|
| Schale | R [mm] | K | ZS [mm] | ZV [mm] | ZH [mm] |
| 1 | 1.5866 | -1.0201 | -0.79 | 108.99 | 185.86 |
| 2 | 2.3481 | -1.0286 | -1.17 | 107.92 | 183.90 |
| 3 | 3.5076 | -1.0399 | -1.74 | 107.56 | 182.35 |
| 4 | 5.0414 | -1.0571 | -2.49 | 105.05 | 179.53 |
| 5 | 7.2534 | -1.0814 | -3.56 | 102.83 | 177.68 |
| 6 | 10.4354 | -1.1182 | -5.07 | 99.95 | 175.90 |
| 7 | 15.0523 | -1.1755 | -7.22 | 94.87 | 173.09 |
| 8 | 22.3247 | -1.2660 | -10.50 | 88.88 | 169.39 |
| | Ellipsoid | | | | |
| Schale | R[mm] | K | ZS[mm] | ZV[mm] | ZH[mm] |
| 1 | 2.3724 | -0.9971 | -160.94 | 349.66 | 433.46 |
| 2 | 3.3366 | -0.9960 | -168.17 | 353.68 | 440.17 |
| 3 | 4.6059 | -0.9945 | -181.56 | 363.50 | 454.10 |
| 4 | 6.4739 | -0.9923 | -184.74 | 364.03 | 457.33 |
| 5 | 9.0813 | -0.9893 | -189.80 | 366.19 | 463.15 |
| 6 | 12.8589 | -0.9849 | -193.20 | 365.14 | 466.03 |
| 7 | 18.4682 | -0.9783 | -195.28 | 362.33 | 470.02 |
| 8 | 26.8093 | -0.9688 | -202.36 | 362.94 | 480.72 |

Das Ausführungsbeispiel des Woltersystems gemäß Figur 17 mit acht Schalen ist so gewählt, daß alle Schalen in etwa in einer Ebene 181 enden. Damit können alle Schalen in einer Ebene 181 gefaßt werden.

Als Fassung der Schalen bzw. Halterung der Schalen können die in Figur 27 gezeigten Speichenräder dienen, die in der Figur 27 gezeigten Ausführungsform insgesamt vier Stutzspeichen umfassen. Die Stutzspeichen verleihen dem genesteten Kollektor mit einer Vielzahl von Spiegelschalen Stabilität.

Vorzugsweise ist die Blende 180 in oder nahe dieser Ebene angeordnet.

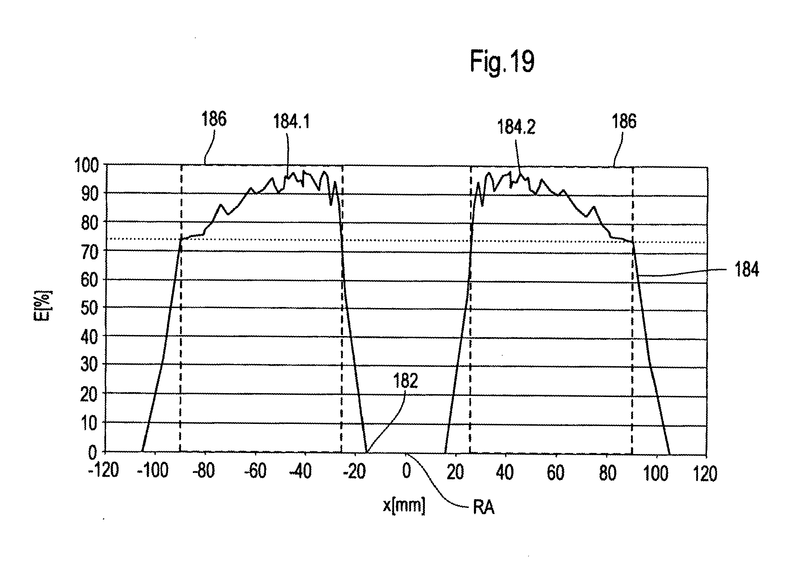

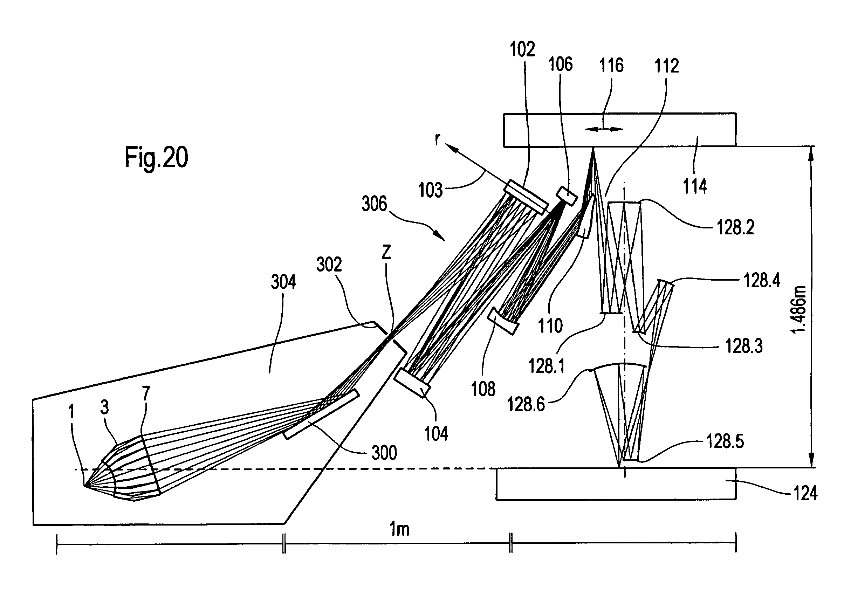

In Figur 19 ist die ermittelte Ausleuchtungsverteilung in der Ebene 7 des Beleuchtungssystems gemäß Figur 20 gezeigt. Das Beleuchtungssystem gemäß Figur 20 umfaßt direkt hinter der Lichtquelle einen 8-schaligen genesteten Kollektor gemäß Figur 17. Der Berechnung der Bestrahlungsstärke gemäß Figur 19 wurde eine Ruthenium-Beschichtung der Spiegelschalen mit deren winkelabhängiger Reflektivität zugrundegelegt. Für andere Beschichtungen kann das Design des Kollektors entsprechend angepaßt werden.

In Figur 19 ist die Mittenabschattung durch die Blende 180 deutlich zu erkennen. Die Mittenabschattung ist mit der Bezugsziffer 182 belegt. Der Verlauf der Intensität in der Ebene 7 ist mit 184 bezeichnet. Deutlich zu erkennen sind zwei zur Rotationsachse RA des Kollektors symmetrische Intensitätspeaks 184.1, 184.2, die in der Ebene 7 zu einer ringförmigen Ausleuchtung führen. Die gestrichelte Kurve 186 gibt den Bereich an, in dem auf dem ersten optischen Element 102 des Beleuchtungssystems gemäß Figur 20 erste Rasterelemente angeordnet sind.

Die optischen Komponenten und der Strahlverlauf einiger Lichtstrahlen einer Projektionsbelichtungsanlage mit einem genesteten Kollektor gemäß Figur 17 sind in Figur 20 gezeigt. Gleiche Bauteile wie bei der Projektionsbelichtungsanlage gemäß Figur 11 sind mit denselben Bezugsziffern belegt.

Im Gegensatz zur Projektionsbelichtungsanlage gemäß Figur 11 ist das Beleuchtungssystem nicht wie ein "X" gefaltet, sondern auf kompakten Bauraum optimiert. Zur Reduktion der Systemlänge ist ferner die bildseitige Apertur des genesteten Kollektors 3, der einen Aufbau wie in Figur 17 hat, auf NA = 0.115 erhöht, wofür die Auslegung als Woltersystem besonders vorteilhaft ist. Die objektseitige Apertur beträgt NA ~ 0.71. Zusätzlich eingefügt ist auf den Kollektor 3 folgend ein Planspiegel 300 zur Faltung des Systems, um Bauräume für mechanische und elektronische Komponenten in der Objektebene 114, in der die Waferstage angeordnet ist, zur Verfügung zu stellen. Das gesamte optische System ist weniger als 3 m lang und weniger als 1.75 m hoch.

Der Planspiegel 300 ist in der vorliegenden Ausführungsform als diffraktives Spektralfilter ausgelegt worden, d.h. durch ein Gitter realisiert. Zusammen mit der Blende 302 in der Nähe des Zwischenbildes Z der Quelle kann damit ungewünschte Strahlung mit beispielsweise Wellenlängen wesentlich größer als der gewünschten Wellenlänge, im vorliegenden Fall 13.5 nm, vom Eintritt in den Teil des hinter der Blende 302 liegenden Beleuchtungssystems abgehalten werden.

Die Blende 302 kann auch dazu dienen, den Raum 304 umfassende Lichtquelle 1, den genesteten Kollektor 3 sowie den als Gitter ausgelegten Planspiegel 300 vom nachfolgenden Beleuchtungssystem 306 räumlich zu trennen. Werden beide Räume durch das Einbringen eines Ventiles nahe des Zwischenfokus Z getrennt, so ist auch eine druckmäßige Trennung möglich. Durch eine räumliche beziehungsweise eine druckmäßige Trennung kann verhindert werden, daß Verschmutzungen, die von der Lichtquelle herrühren in das hinter der Blende 302 liegende Beleuchtungssystem gelangen.

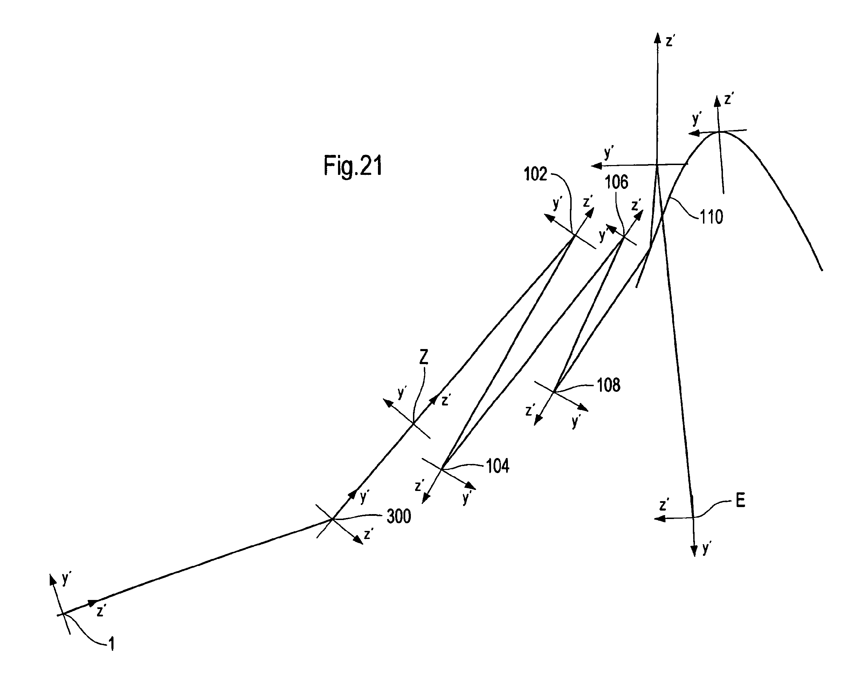

Das in Figur 20 gezeigte Beleuchtungssystem umfaßt einen genesteten Kollektor 3 mit 8 Schalen gemäß Figur 17 sowie Tabelle 3. Der Planspiegel 200 des Designs gemäß Figur 20 ist als Spektralfilter mit einem Beugungswinkel von 2° zwischen 0. und genutzter Beugungsordnung ausgebildet. Das erste optische Element 102 umfaßt 122 erste Rasterelemente mit einer Ausdehnung von jeweils 54 mm x 2.75 mm. Das zweite optische Element 104 weist 122 den ersten Rasterelementen zugeordneten zweiten Rasterelementen mit einem Durchmesser von jeweils 10 mm. Alle Ortsangaben der optischen Komponenten in Tabelle 4 sind auf das Referenz-Koordinatensystem in der Objektebene 114 bezogen. Die Drehung um den Winkel $\alpha$ um die lokale x-Achse der der jeweiligen optischen Komponente zugeordneten lokalen Koordinatensysteme ergeben sich nach translatorischer Verschiebung des Referenz-Koordinationssystemes an den Ort des lokalen Koordinatensystems. Die Parameter der optischen Komponenten des Beleuchtungssystems gemäß Figur 20 sind in Tabelle 4 angegeben. In Tabelle 4 sind die Positionen der Scheitelpunkte der einzelnen optischen Elemente bezüglich der Objektebene 114 angegeben und die Drehwinkel $\alpha$ der Koordinatensysteme um die x-Achse. Des weiteren werden rechtshändige Koordinatensysteme und Drehung im Uhrzeigersinn zugrundegelegt. Neben den lokalen Koordinatensystemen der optischen Komponenten sind die lokalen Koordinatensysteme des Zwischenfokusses Z und der Eintrittspupille E angegeben. Der feldformende Spiegel 110 besteht aus einem außeraxialen Segment eines Rotationshyperboloids. Die Koordinatensysteme für sämtliche in Tabelle 4 beschriebenen optischen Elemente des Beleuchtungssystem gemäß Figur 20 ausgenommen dem genesteten Kollektor 3 sind in Figur 21 gezeigt. Sämtliche optischen Elemente sind mit denselben Bezugsziffern wie in Figur 20 belegt.

Das System ist für einen Feldradius von 130 mm bei einer Beleuchtungsapertur von NA = 0.03125 in der Objektebene 114, d. h. am Retikel ausgelegt, entsprechend einem Füllgrad von $\sigma$ = 0.5 in der Eintrittspupille E eines nachfolgenden 4:1-Projektionsobjektives mit einer Apertur NA = 0.25 in der Ebene 124 des zu belichtenden Objektes.

Tabelle 4: Designdaten des Systems gemäß Figur 20

| Position | Y | Z | $\alpha$ | Scheitelkrümmungsradius | konische Konstante |
|---|---|---|---|---|---|
| Licht-Quelle 1 | 2148.137 | -1562.205 | 70.862 | - keine Spiegelfläche - | |
| Planspiegel bzw. Spektralfilter 200 | 1184.513 | -1227.797 | 147.434 | Plan | |
| Zwischenfokus Z | 883.404 | -893.382 | 42.000 | - keine Spiegelfläche - | |
| Erstes facettiertes optisches Element 102 | 302.599 | -248.333 | 36.000 | -898.54 | Sphärisch |
| Zweites facettiertes optisches Element 104 | 773.599 | -1064.129 | 214.250 | -1090.15 | Sphärisch |
| Spiegel 106 | 126.184 | -250.216 | 31.500 | 288.1 | Sphärisch |
| Spiegel 108 | 372.926 | -791.643 | 209.600 | -855.8 | Sphärisch |
| Spiegelscheitel von Spiegel 110 | -227.147 | 118.541 | -4.965 | -80.5 | -1.1485701 |
| Objektebene 114 | 0.000 | 0.000 | 0.000 | Plan | |
| Eintrittspupille E | -130.000 | -1236.867 | 0.000 | - keine Spiegelfläche - | |

Wie der in den Figuren 1 bis 13 gezeigte genestete Kollektor, so können auch die Schalen des Woltersystems einfach durch Abformtechniken hergestellten werden.

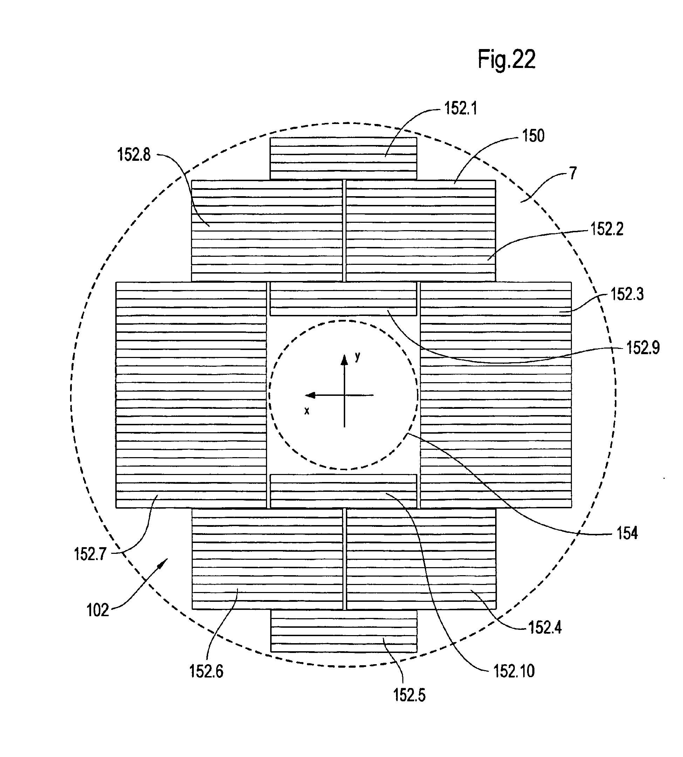

In Figur 22 ist das erste optische Element 102 in der Ebene 103 des Beleuchtungssystems gemäß Figur 20 mit lokalem x-y-Koordinatensystem gezeigt. Deutlich zu erkennen ist die Anordnung der 122 ersten Rasterelemente 150.

Die ersten Rasterelemente 150 sind in zehn zueinander beabstandeten Blöcken 152.1, 152.2, 152.3, 152.4, 152.5, 152.6, 152.7, 152.8, 152.9, 152.10 angeordnet.

In dem durch die Zentralabschattung 154 des Kollektors 3 nicht ausgeleuchteten Bereiches in der Ebene 103 sind keine ersten Rasterelemente 150 angeordnet. Die maximale Abweichung der Bestrahlungsstärke zwischen einzelnen ersten Rasterelementen 150 ist bei Einsatz eines genesteten Kollektors gemäß Figur 17 kleiner als $\pm 15\%$.

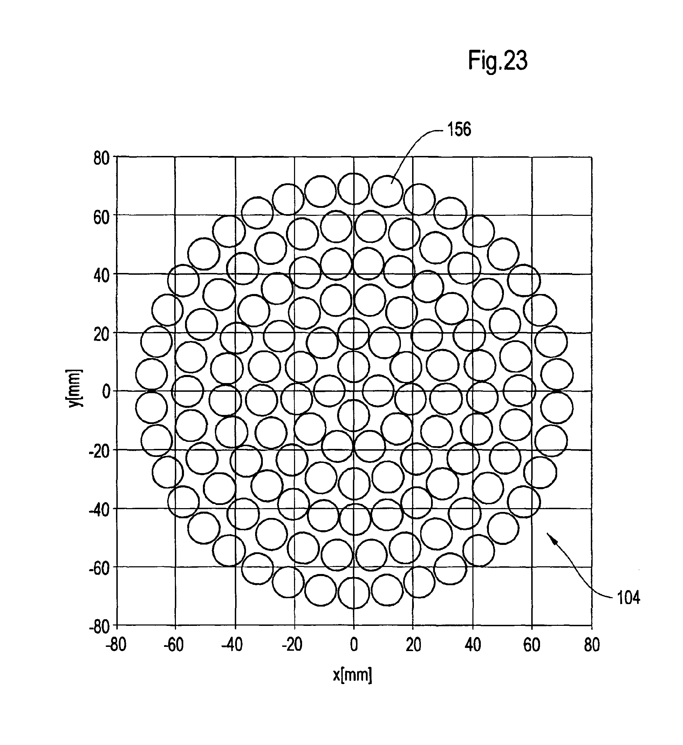

Figur 23 zeigt die Anordnung der zweiten Rasterelemente 156 auf dem zweiten optischen Element 104. Die Bilder der zweiten Rasterelemente 156 füllen die Austrittspupille des Beleuchtungssystemes kontinuierlich bis zu einem gegebenen Füllgrad von $\sigma = 0.5$. Betreffend die Definition des Füllgrades in der Austrittspupille wird auf die WO 01/09684 verwiesen, deren Offenbarungsgehalt vollumfänglich in die vorliegende Anmeldung mitaufgenommen wird.

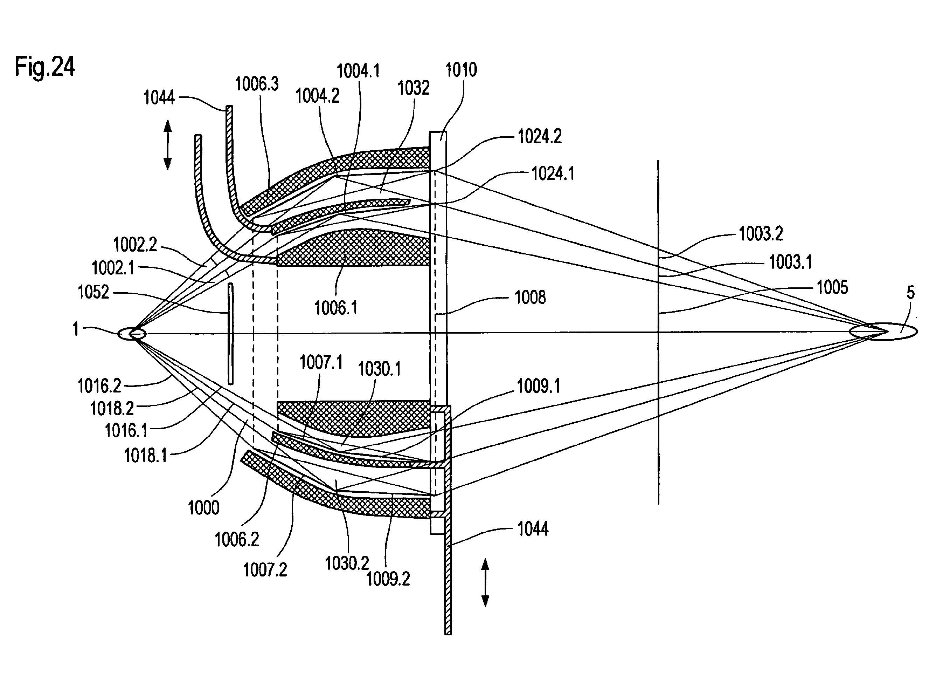

In Figur 24 ist eine erste Ausführungsform eines erfindungsgemäßen genesteten Kollektors mit beispielsweise zwei ineinander angeordneten Spiegelschalen 1004.1, 1004.2 gezeigt, bei denen die Ringaperturelemente wie bei dem genesteten Kollektor gemäß Figur 15 eine Lücke 1000 zwischen den objektseitigen Ringaperturelementen 1002.1 und 1002.2 der ersten Spiegelschale 1004.1 und der zweiten Spiegelschale 1004.2 aufweist. Die bildseitigen Ringelelemente 1003.1, 1003.2 schließen direkt aneinander an, so dass im Bildraum bis auf die notwendige Zentralabschattung 1005 keine Lücke vorliegt. Bei dem dargestellten Kollektor sind Im ungenutzten Bereich der zwischen den beiden Spiegelschalen 1004.1, 1004.2 sowie innerhalb und außerhalb des Kollektors Kühleinrichtungen 1006.1, 1006.2, 1006.3 angeordnet. Die Spiegelschalen 1004.1, 1004.2 enden in etwa einer Ebene und können in dieser Ebene 1008 beispielsweise durch ein Speichenrad, von dem eine Speiche 1010 gezeigt ist, gefaßt werden. Jede Spiegelschale 1004.1, 1004.2 der dargestellten Ausführungsform umfasst zwei Spiegelsegmente, ein erstes Spiegelsegment 1007.1, 1007.2 mit einer ersten optischen Fläche und ein zweites Spiegelsegment 1009.1, 1009.2 mit einer zweiten optischen Fläche, die ohne Lücke hintereinander angeordnet sind. Die ersten Spiegelsegmente 1007.1, 1007.2 sind in vorliegendem Ausführungsbeispiel Segmente von Hyperboloiden und die zweiten Spiegelsegmente 1009.1, 1009.2 Segmente von Ellipsoiden.

Wie im in Figur 24 gezeigten Meridonalschnitt deutlich zu sehen ist, definieren der inneren und äußeren Randstrahl 1016.1, 1016.2, 1018.1, 1018.2 der jeweiligen Spiegelschale beziehungsweise die diesen zugeordneten Verbindungslinien zwischen der Quelle 1, dem Bild der Quelle 5, den Schalenenden 1024.1, 1024.2 und bei Systemen mit zwei Spiegelsegmenten zusätzlich der Übergangsbereich zwischen dem ersten 1007.1, 1007.2 und dem zweiten Spiegelsegment 1009.1 1009.2 einen optisch genutzten Bereich oder ein sogenanntes Strahlrohr durch welchen der Strahlungsfluß vom Objekt bzw. von der Lichtquelle 1 zum Bild 5 der Lichtquelle fließt. Ein Meridonalschnitt oder eine Meridonalebene ist jede Ebene, welche die Rotationsachse RA umfasst. Zwischen den genutzten Bereichen 1030.1., 1030.2 von mindestens zwei ineinander angeordneten Spiegelschalen 1004.1, 1004.2 liegt nun ein ungenutzter Bereich 1032. Dieser Bereich liegt vollständig im Schattenbereich der inneren Kollektorschale 1004.1. Zusätzlich kann der ungenutzte Bereich wie bei dem vorliegenden Ausführungsbeispiel und bei dem Ausführungsbeispiel gemäß Figuren 15 und 16 in einer vorderen Aperturlücke 1000, d.h. einer Lücke zwischen den Ringaperturelementen 1002.1, 1002.2 liegen. Diese objektseitige Aperturlücke 1000 wird nicht in das Bild 5 der Lichtquelle übertragen und bleibt daher ungenutzt..

In dem ungenutzten Bereich 1032 zwischen zwei Spiegelschalen 1004.1, 1004.2 können weitere Komponenten des genesteten Kollektors angeordnet werden ohne den Strahlungsfluß von der Lichtquelle 1 zum Bild der Lichtquelle 5 zu beeinflussen. Beispiele für derartige Komponenten wären Detektoren oder Auskoppelspiegel welche Licht auf Detektoren umlenken oder nicht optische Komponenten wie Wärmeschilde oder Kühlfallen. Die Kühleinrichtungen 1006.1, 1006.2, 1006.3 können in direktem Kontakt mit den Rückseiten der Kollektorschalen stehen. Auch die Anordnung von Elektroden oder Magneten zur Ablenkung von geladenen oder magnetischen Teilchen ist möglich. Elektrische Leitungen oder Leitungen zur Zu- und Abfuhr von Kühlmittel können bei nur geringfügiger Abschattung der bildseitigen Kollektorapertur, d.h. des ausgeleuchteten Bereiches in der bildseitigen Ebene nach außerhalb des Kollektors geführt werden. Bevorzugt werden diese Leitungen 1044 im Bereich der Schatten der notwendigen Halteeinrichtungen der Spiegelschalen beispielsweise des Speichenrades mit Speichen 1010 geführt. Natürlich können weitere Kühlelemente oder Detektoren auch in Bereichen außerhalb der äußersten Schale 1004.2 oder der Zentralabschattung 1052 angeordnet werden. Im Bereich der Zentralabschattung kann bevorzugt auch eine Blende angeordnet werden, wie beispielsweise in Figur 8 gezeigt.

In Figur 25 ist ein weiteres Ausführungsbeispiel der Erfindung gezeigt. Das in Figur 25 gezeigte Ausführungsbeispiel zeigt wiederum ein System mit zwei Spiegelschalen 1104.1, 1104.2. Gleiche Bauelemente wie in Figur 24 weisen eine um 100 erhöhte Bezugsziffer auf. Im Gegensatz zur Ausführungsform in Figur 24 handelt es sich bei dem in Figur 24 dargestellten Kollektor um ein System, bei dem jede Spiegelschale nur ein einziges Segment 1107.1, 1109.1, nämlich das Segment eines Ellipsoides umfasst. Desweiteren weist das Ringaperturelement keine Lücken auf. Im ungenutzten Bereich 1132 zwischen den beiden Spiegelschalen 1104.1, 1104.2, ist vorliegend eine ringförmig ausgebildet e Kühleinrichtung 1106.1, 1106.2 in Form beispielsweise von Ringplatten , angeordnet sein. Die Ringplatte wird wiederum bevorzugt von einem Kühlmittel durchflossen. Die Zu- und Abfuhr des Kühlmittels erfolgt über Kühlleitungen 1144, die von der Kühlplatte 1106.1, 1106.2 zu einer Speiche 1110, der die einzelnen Spiegelschalen wie zuvor beschrieben faßt, führt. Die Ausbildung der Kühleinrichtung als ringförmige Platte kann eine großflächige effektive homogene und rotationssymmetrische Kühlung erreicht werden. Die Platten können entweder fest mit der Spiegelschale verbunden sein, beispielsweise durch galvanisches Aufwachsen. Die Wärmeabfuhr erfolgt dann durch Wärmeleitung. Alternativ können die Schalen auch lediglich aufgelegt sein. Hierdurch.werden gegenseitige Beeinflussungen aufgrund einer Wärmeausdehnung der Spiegelschale bzw. der Kühlplatte vermieden. Die Wärmeabfuhr erfolgt dann ausschließlich durch Strahlung.

Die Kühleinrichtungen können auch als Kühlringe, die um den vollen Umfang des Kollektors umlaufen, ausgebildet sein. In Figur 26 sind derartige Kühlringe und insbesondere Ihre Halterung gezeigt. Die Kühlringe 1200.1 und 1200.2 sind in dem ungenutzten Raum zwischen zwei Spiegelschalen eines Kollektors mit beispielsweise zwei Segmenten je Spiegelschale angeordnet. Ein derartiger zweischaliger Wolter-Kollektor ist im Meridonalschnitt beispielsweise in Figur 24 dargestellt. Die Kühlringe 1200.1, 1200.2 werden an im Schatten der Speichen des Speichenrades verlaufende und sich in Richtung der Rotationsachse erstreckenden Haltestrukturen bzw. Stegen 1202.1, 1202.2, 1202.3, 1202.4 gehalten. Die Verbindung der Kühlringe 1200.1 und 1200.2 mit den Haltestegen 1202.1, 1202.2, 1202.3, 1202.4 kann beispielsweise über eine Lötverbindung erfolgen. Diese garantiert einen guten mechanischen und thermischen Kontakt. Die Stege sind bevorzugt aus einem Material guter Wärmeleitfähigkeit hergestellt, beispielsweise Kupfer, und gut lötbar. Die Kühlringe 1202.1, 1202.2 sind ebenfalls bevorzugt aus einem gut wärmeleitfähigen Material wie Kupfer oder Stahl.

Die Stege 1202.1, 1202.2, 1202.3, 1202.4 werden an den vier Speichen 1204.1, 1204.2, 1204.3, 1204.4 eines Speichenrades, das die einzelnen Spiegelschalen faßt und befestigt, beispielsweise mittels von Schrauben. Die Speichen verlaufen in radialer Richtung, d.h. in einer Richtung senkrecht zur Rotationsachse.

Mit der Erfindung wird erstmals ein Kollektor angegeben, der eine beliebige Lichtquelle in ein Bild der Quelle abbildet. Das Quellbild kann reell, virtuell oder im Unendlichen liegen. Die Abstrahlcharakteristik der beliebigen Lichtquelle wird so umtransformiert, daß sich in einer Ebene vor oder hinter dem Zwischenbild eine weitgehend homogene Ausleuchtung ergibt.

**Patentansprüche**

1. Kollektor für Beleuchtungssysteme mit einer Wellenlänge $\leq$ 193 nm, bevorzugt $\leq$ 126 nm, besonders bevorzugt EUV-Wellenlängen zur Aufnahme des Lichtes einer Lichtquelle (1) über eine objektseitige Apertur und zur Ausleuchtung eines Bereiches in einer bildseitigen Ebene (7) mit einer Vielzahl von rotationssymmetrischen Spiegelschalen (40, 42, 44, 46, 200, 202, 204), wobei die Spiegelschalen um eine gemeinsame Rotationsachse (RA) ineinander angeordnet sind und die Spiegelschalen (40, 42, 44, 46, 200, 202, 204) ein von der Lichtquelle (1) einfallendes Lichtbuschel (49.1, 49.2, 49.3, 49.4) aufnehmen und in Richtung der bildseitigen Ebene (7) reflektieren und zwischen zwei benachbarten Spiegelschalen einen vom Licht genutzten Bereich definieren, **dadurch gekennzeichnet, dass** die Spiegelschalen (40, 42, 44, 46, 200, 202, 204) derart ausgebildet sind, dass mindestens ein vom Licht ungenutzter (51.1, 51.2, 51.3, 51.4, 213.1, 213.2) Bereich zwischen mindestens zwei benachbarten Spielgelschalen ausgebildet wird und im vom Licht ungenutzten Bereich (51.1, 51.2, 51.3, 51.4, 213.1, 213.2) zwischen zwei benachbarten Spiegelschalen weitere Komponenten angeordnet sind.

2. Kollektor nach Anspruch 1 wobei die Vielzahl von rotationssymmetrischen Spiegelschalen (40, 42, 44, 46, 200, 202, 204) jeweils wenigstens ein erstes Spiegelsegment (200.1, 202.1) umfassend eine erste optische Fläche (200.2, 202.2) aufweisen und jede Spiegelschale ein Ringaperturelement (20, 22, 24) der objektseitigen Apertur zugeordnet ist , wobei der ersten optischen Fläche ein Anfangs- und ein Endpunkt in einer Meridonalebene zugeordnet ist, wobei die Merdionalebene eine Ebene ist, welche die Rotationsachse (RA) umfasst und der Anfangspunkt der ersten optischen Fläche in der Meridonalebene einen äußeren Randstrahl (41.2, 43.2, 45.2, 47.2, 205.2, 207.2, 209.2) und der Endpunkt der ersten optischen Fläche in der Meridonalebene einen inneren Randstrahl (41.1, 43.1, 45.1, 47.1, 205.1, 207.1, 209.1) definiert und innerer und äußerer Randstrahl rotiert um die Rotationsachse (RA) das Lichtbüschel begrenzen, das mindestens an der ersten optischen Fläche der Spiegelschale reflektiert wird und den Kollektor von der objektseitigen Apertur zur auszuleuchtenden Ebene (7) durchläuft, wobei das Lichtbüschel den vom Licht genutzten Bereich zwischen mindestens zwei benachbarten Spiegelschalen definiert.

3. Kollektor gemäß Anspruch 1 oder 2, **dadurch gekennzeichnet, daß** die weiteren Komponenten Detektionsmittel und/oder Auskoppelspiegel und/oder Elemente ohne optische Wirkung wie Abschirmeinrichtungen und/oder Kühleinrichtungen (203.1, 203.2, 203.3, 1006.1, 1006.2, 1006.3) und/oder Befestigungseinrichtungen umfassen.

4. Kollektor nach einem der Ansprüche 1 bis 3, **dadurch gekennzeichnet, daß** der auszuleuchtende Bereich in einer Ebene (7) liegt und aus Ringelementen (30, 32, 34, 230, 232, 234) besteht, wobei jedem Ringelement (30, 32, 34, 230, 232, 234) ein Ringaperturelement (20, 22, 24, 210, 212, 214) zugeordnet ist und die Ausdehnung in Richtung der Rotationsachse, die Flächenparameter und die Position der Spiegelschalen derart gewählt sind, dass die Bestrahlungsstärken der einzelnen Ringelemente in der Ebene (7) weitgehend übereinstimmen.

5. Kollektor nach Anspruch 4 **dadurch gekennzeichnet, dass** die Ringelemente (30, 32, 34, 230, 232, 234) kontinuierlich aneinander anschließen.

6. Kollektor nach einem der Ansprüche 1 bis 5, **dadurch gekennzeichnet, dass** mindestens zwei Ringaperturelemente (20, 22, 24, 210, 212, 214) nicht kontinuierlich aneinander anschließen und zwischen diesen eine Lücke (26, 220, 222) ausgebildet wird.

7. Kollektor nach Anspruch 6, **dadurch gekennzeichnet, dass** die weiteren Komponenten, insbesondere die Elemente ohne optische Wirkung, insbesondere die Kühleinrichtungen, (203.1, 203.2, 203.3, 1006.1, 1006.2, 1006.3) im Bereich der Lücken (26, 220, 222) der Ringaperturelemente angeordnet sind.

8. Kollektor nach einem der Ansprüche 1 bis 7, **dadurch gekennzeichnet, dass** die Spiegelschalen ringförmige Segmente von Asphären sind.

9. Kollektor nach Anspruch 8, **dadurch gekennzeichnet, dass** die Spiegelschalen ein ringförmiges Segment eines Ellipsoides oder eines Paraboloides oder eines Hyperboloides sind.

10. Kollektor nach einem der Ansprüche 1 bis 7, **dadurch gekennzeichnet, dass** mindestens eine Spiegelschale (200, 202, 204), ein erstes Segment (200.1, 202.1, 204.1) mit einer ersten optischen Flachen (200.2, 202.2, 204.2) und ein zweites Segment (200.3, 202.3, 204.3) mit einer zweiten optischen Flache (200.4, 202.4, 204.4) umfasst.

11. Kollektor nach Anspruch 10, **dadurch gekennzeichnet, dass** die erste optische Fläche und die zweite optische Fläche einer Spiegelschale nicht kontinuierlich aneinander anschließen und eine Lücke zwischen ersten optischer Fläche und zweiter optischen Fläche einer Spiegeischale ausgebildet wird.

12. Kollektor nach Anspruch 11, **dadurch gekennzeichnet dass** die weiteren Komponenten, insbesondere die Kühleinrichtungen (203.1, 203.2, 203.3, 1006.1, 1006.2, 1006.3) in der Lücke zwischen erster optischer Fläche und zweiter optischer Fläche der Spiegelschale angeordnet sind.

13. Kollektor nach einem der Ansprüche 10 bis 12, **dadurch gekennzeichnet, dass** das erste ringförmige Segment ein Ausschnitt eines Hyperboloides und das zweite ringförmige Segment ein Ausschnitt eines Ellipsoides ist.

14. Kollektor nach einem der Ansprüche 10 bis 12, **dadurch gekennzeichnet, dass** das erste ringförmige Segment ein Ausschnitt eines Hyperboloides und das zweite ringförmige Segment ein Ausschnitt eines Paraboloides ist.

15. Kollektor nach einem der Ansprüche 1 bis 14, **dadurch gekennzeichnet, dass** die Kühleinrichtungen Kühlkanäle umfassen, die von Kühlmittel umströmt werden.

16. Kollektor nach einem der Ansprüche 1 bis 15, **dadurch gekennzeichnet, dass** der Kollektor Halteeinrichtungen (1202.1, 1202.2, 1202.3, 1202.4) umfasst.

17. Kollektor nach Anspruch 16, **dadurch gekennzeichnet, dass** die Halteeinrichtungen Stützspeichen (1204.1, 1204.2, 1204.3, 1204.4) umfassen, die sich in radialer Richtung der Spiegelschalen erstrecken.

18. Kollektor nach Anspruch 17, **dadurch gekennzeichnet, dass** die Kühleinrichtungen Zufuhr- und Abfuhreinrichtungen für das Kühlmittel umfassen und die Zufuhr- und Abfuhreinrichtungen im Bereich der Halteeinrichtungen angeordnet sind.

19. Kollektor nach einem der Ansprüche 1 bis 18, **dadurch gekennzeichnet, dass**
die Strahlen des von der Lichtquelle ausgehenden Strahlbüschels mit Einfallswinkeln < 20˚ zur Flächentangente der Spiegelschalen auftreffen.

20. Beleuchtungssystem für Wellenlängen ≤ 193 nm, insbesondere < 126 nm, besonders bevorzugt im EUV-Bereich, mit

> 1) einer Lichtquelle (1)
> 2) wenigstens einem Kollektor (3)

3) einer auszuleuchtenden Ebene (7, 103)
**dadurch gekennzeichnet, dass**
4) der Kollektor ein Kollektor (3) gemäß einem der Ansprüche 1 bis 20 ist.

**21.** Beleuchtungssystem für Wellenlängen ≤ 193 nm, insbesondere < 126 nm, besonders bevorzugt im EUV-Bereich, gemäß Anspruch 20, **dadurch gekennzeichnet, daß** das Beleuchtungssystem des weiteren ein erstes optisches Element (102), umfassend erste Rasterelemente (150) aufweist.

**22.** Beleuchtungssystem für Wellenlängen ≤ 193 nm, insbesondere < 126 nm, besonders bevorzugt im EUV-Bereich gemäß Anspruch 21,
**dadurch gekennzeichnet, dass** der Kollektor (3) in der auszuleuchtenden Ebene (7, 103) einen ringförmigen Bereich ausleuchtet und dass die ersten Rasterelemente (150) des ersten optischen Elementes (102), das in der auszuleuchtenden Ebene (7, 103) angeordnet ist, annähernd innerhalb des ringförmigen Bereiches angeordnet sind.

**23.** Beleuchtungssystem für Wellenlängen ≤ 193 nm, insbesondere < 126 nm, besonders bevorzugt im EUV-Bereich, gemäß Anspruch 21 oder 22, **dadurch gekennzeichnet, dass** das Beleuchtungssystem des weiteren optische Elemente (106, 108, 110) zur Abbildung und/oder Feldformung umfasst.

**24.** Beleuchtungssystem für Wellenlängen ≤ 193 nm, insbesondere < 126 nm, besonders bevorzugt im EUV-Bereich, gemäß einem der Ansprüche 21 bis 23, **dadurch gekennzeichnet, dass** das Beleuchtungssystem zwischen dem Kollektor (3) und der auszuleuchtenden Ebene (103) eine zur Lichtquelle (1) konjugierte Ebene umfasst, in der ein Zwischenbild (Z) der Lichtquelle (1) ausgebildet wird.

**25.** Beleuchtungssystem für Wellenlängen ≤ 193nm, insbesondere < 126nm, besonders bevorzugt im EUV-Bereich gemäß Anspruch 24, **dadurch gekennzeichnet, dass** im oder nahe dem Zwischenbild (Z) eine Blende (202) angeordnet ist, die einen Raum umfassend mindestens die Lichtquelle (1) und den Kollektor (3) räumlich und/oder druckmäßig vom nachfolgenden Beleuchtungssystem trennt.

**26.** EUV-Projektionsbelichtungsanlage mit

1) einem Beleuchtungssystem gemäß einem der Ansprüche 19 bis 24,
2) einer Maske, die von dem Beleuchtungssystem beleuchtet wird,
3) ein Projektionsobjektiv (126) zur Abbildung der Maske auf
4) ein lichtsensitives Objekt.

**27.** Verfahren zur Herstellung von mikroelektronischen Bauteilen mit einer EUV-Projektionsbelichtungsanlage gemäß Anspruch 26, wobei eine Maske beleuchtet wird und auf ein lichtsensitives Objekt abgebildet wird.

**Claims**

**1.** A collector for illumination systems with a wavelength ≤ 193 nm, preferably ≤ 126 nm, more preferably EUV wavelengths for receiving light emitted from a light source (1) via an aperture on the object side and for illuminating an area in an image-side plane (7) with a plurality of rotational-symmetrical mirror shells (40, 42, 44, 46, 200, 202, 204), with the mirror shells being arranged about a common rotational axis (RA) in each other, and the mirror shells (40, 42, 44, 46, 200, 202, 204) receiving a light pencil (49.1, 49.2, 49.3, 49.4) impinging from the light source (1) and reflecting the same in the direction of the image-side plane (7), and defining a region utilized by the light between two adjacent mirror shells, **characterized in that** the mirror shells (40, 42, 44, 46, 200, 202, 204) are arranged in such a way that at least one region (51.1, 51.2, 51.3, 51.4, 213.1, 213.2) which is not utilized by the light is formed between at least two adjacent mirror shells and further components are arranged in the region (51.1, 51.2, 51.3, 51.4, 213.1, 213.2) which is not utilized by the light between two adjacent mirror shells.

**2.** A collector according to claim 1, wherein the plurality or rotational-symmetrical mirror shells (40, 42, 44, 46, 200, 202, 204) comprise at least one first mirror segment (200.1, 202.1) comprising a first optical surface (200.2, 202.2) and each mirror shell is associated with a ring aperture element (20, 22, 24) of the objectside aperture, with the first optical surface being associated with a starting and end point in a meridional plane, with the meridional plane being a plane which comprises the rotational axis (RA) and the starting point of the first optical surface in the meridional plane defines a first outer marginal ray (41.2, 43.2, 45.2, 47.2, 205.2, 207.2, 209.2) and the end point of the first optical surface in the meridional plane defines an inner marginal ray (41.1, 43.1, 45.1, 47.1, 205.1, 207.1, 209.1), and the inner and outer marginal ray, by rotating about the rotational axis (RA), delimit the light pencil which is reflected at least on the first optical surface of the mirror shell and passes through the collector of the objectside aperture to the plane (7) to be illuminated, with the light pencil defining the area utilized by the light between at least two adjacent mirror shells.

3. A collector according to claim 1 or 2, **characterized in that** the further components comprise detection means and/or output coupler mirrors and/or elements without any optical effects such as screening devices (203.1, 203.2, 203.3, 1006.1, 1006.2, 1006.3) and/or cooling devices and/or fastening devices.

4. A collector according to one of the claims 1 to 3, **characterized in that** the area to be illuminated lies in a plane (7) and consists of ring elements (30, 32, 34, 230, 232, 234), with each ring element (30, 32, 34, 230, 232, 234) being associated with a ring aperture element (20, 22, 24, 210, 212, 214) and the extension in the direction of the rotational axis, the surface parameters and the position of the mirror shells are chosen in such a way that the irradiances of the individual ring elements in the plane (7) correspond substantially.

5. A collector according to claim 4, **characterized in that** the ring elements (30, 32, 34, 230, 232, 234) are adjacent to one another continuously.

6. A collector according to one of the claims 1 to 5, **characterized in that** at least two ring aperture elements (20, 22, 24, 210, 212, 214) are not continuously adjacent to one another and a gap (26, 220, 222) is formed between the same.

7. A collector according to claim 6, **characterized in that** the further components, especially the elements without any optical effects, especially the cooling devices (203.1, 203.2, 203.3, 1006.1, 1006.2, 1006.3), are arranged in the region of the gaps (26, 220, 222) of the ring aperture elements.

8. A collector according to one of the claims 1 to 7, **characterized in that** the mirror shells are annular segments of aspherics.

9. A collector according to claim 8, **characterized in that** the mirror shells are an annular segment of an ellipsoid or a paraboloid or a hyperboloid.

10. A collector according to one of the claims 1 to 7, **characterized in that** at least one mirror shell (200, 202, 204) comprises a first segment (200.1, 202.1, 204.1) with a first optical surface (200.2, 202.2, 204.2) and a second segment (200.3, 202.3, 204.3) with a second optical surface (200.4, 202.4, 204.4).

11. A collector according to claim 10, **characterized in that** the first optical surface and the second optical surface of a mirror shell are not continuously adjacent to one another and a gap is formed between the first optical surface and the second optical surface of a mirror shell.

12. A collector according to claim 11, **characterized in that** the further components, especially the cooling devices (203.1, 203.2, 203.3, 1006.1, 1006.2, 1006.3), are arranged in the gap between first optical surface and second optical surface of the mirror shell.

13. A collector according to one of the claims 10 to 12, **characterized in that** the first annular segment is a section of a hyperboloid and the second annular segment is a section of an ellipsoid.

14. A collector according to one of the claims 10 to 12, **characterized in that** the first annular segment is a section of a hyperboloid and the second annular segment is a section of a paraboloid.

15. A collector according to one of the claims 1 to 14, **characterized in that** the cooling device comprises cooling ducts, with coolant flowing around the same.

16. A collector according to one of the claims 1 to 15, **characterized in that** the collector comprises holding devices (1202.1, 1202.2, 1202.3, 1202.4).

17. A collector according to claim 16, **characterized in that** the holding devices (1202.1, 1202.2, 1202.3, 1202.4) comprise support spokes which extend in the radial direction of the mirror shells.

18. A collector according to claim 17, **characterized in that** the cooling devices comprise feed and discharge devices for the coolant and the feed and discharge devices are arranged in the region of the holding devices.

19. A collector according to one of the claims 1 to 18, **characterized in that** the rays of the ray pencil emitted by the light source impinge with incidence angles < 20˚ in relation to the surface tangent of the mirror shells.

20. An illumination system for wavelengths ≤ 193 nm, especially ≤ 126 nm, more preferably in the EUV range, comprising a light source (1), at least one collector (3), a plane (7, 103) to be illuminated, **characterized in that** the collector is a collector (3) according to one of the claims 1 to 20.

21. An illumination system for wavelengths ≤ 193 nm, especially ≤ 126 nm, more preferably in the EUV range, in accordance with claim 20, **characterized in that** the illumination system further comprise a first optical element (102) comprising first raster elements (150).

22. An illumination system for wavelengths ≤ 193 nm, especially ≤ 126 nm, more preferably in the EUV range, according to claim 21, **characterized in that** the collector (3) illuminates an annular area in the plane (7, 103) to be illuminated and the first raster elements (150) of the first optical element (102) which is arranged in the plane (7, 103) to be illuminated are arranged approximately within the annular area.

23. An illumination system for wavelengths ≤ 193 nm, especially ≤ 126 nm, more preferably in the EUV range, according to claim 21 or 22, **characterized in that** the illumination system further comprises optical elements (106, 108, 110) for projection and/or field forming.

24. An illumination system for wavelengths ≤ 193 nm, especially ≤ 126 nm, more preferably in the EUV range, according to one of the claims 21 to 23, **characterized in that** the illumination system comprises a plane conjugated to the light source (1) between the collector (3) and the plane (103) to be illuminated, in which plane an intermediate image (Z) of the light source (1) is formed.

25. An illumination system for wavelengths ≤ 193 nm, especially ≤ 126 nm, more preferably in the EUV range according to claim 24, **characterized in that** a stop (202) is arranged in or close to the intermediate image (Z) which separates a space comprising at least the light source (1) and the collector (3) in a spatial and/or pressure-related manner from the subsequent illumination system.

26. An EUV projection exposure system, comprising an illumination system according to one of the claims 19 to 24, a mask which is illuminated by the illumination system, a projection lens (126) for projecting the mask to a light-sensitive object.

27. A method for producing microelectronic components with an EUV projection exposure system according to claim 26, with a mask being illuminated and projected to a light-sensitive object.

**Revendications**

1. Collecteur pour des systèmes d'éclairage ayant une longueur d'ondes ≤ 193 nm, de préférence ≤ 126 nm, en particulier des longueurs d'ondes dans les UVE, destiné à collecter la lumière d'une source lumineuse (1) via une ouverture du côté de l'objet et à éclairer une zone dans un plan (7) du côté de l'image avec une pluralité de coques de miroir symétriques en rotation (40, 42, 44, 46, 200, 202, 204), lesquelles coques de miroir sont disposées les unes dans les autres autour d'un axe de rotation commun (RA) et lesquelles coques de miroir (40, 42, 44, 46, 200, 202, 204) recueillent un faisceau lumineux (49.1, 49.2, 49.3, 49.4) provenant de la source lumineuse (1) et le réfléchissent en direction du plan (7) du côté de l'image et définissent entre deux coques de miroir voisines une zone utilisée par la lumière, **caractérisé en ce que** les coques de miroir (40, 42, 44, 46, 200, 202, 204) sont conformées de telle manière qu'au moins une zone non utilisée par la lumière (51.1, 51.2, 51.3, 51.4, 213.1, 213.2) est formée entre au moins deux coques de miroir voisines et d'autres composants sont disposés dans la zone non utilisée par la lumière (51.1, 51.2, 51.3, 51.4, 213.1, 213.2) entre deux coques de miroir.

2. Collecteur selon la revendication 1, dans lequel la pluralité des coques de miroir (40, 42, 44, 46, 200, 202, 204) symétriques en rotation présentent chacune un premier segment de miroir (200.1, 202.1) comprenant une première surface optique (200.2, 202.2) et chaque coque de miroir est associée à un élément d'ouverture annulaire (20, 22, 24) de l'ouverture du côté de l'objet, la première surface optique étant associée à un point de début et un point de fin dans un plan méridional, lequel plan méridional est un plan renfermant l'axe de rotation (RA) et lequel point initial de la première surface optique définit dans le plan méridional un rayon marginal extérieur (41.2, 43.2, 45.2, 47.2, 205.2, 207.2, 209.2) et le point de fin de la première surface optique définit dans le plan méridional un rayon marginal intérieur (41.1, 43.1, 45.1, 47.1, 205.1, 207.1, 209.1) et les rayons marginaux intérieur et extérieurs tournés autour de l'axe de rotation (RA) délimitent le faisceau lumineux qui est réfléchi au moins sur la première surface optique de la coque de miroir et qui parcourt le collecteur de l'ouverture du côté de l'objet au plan (7) à éclairer, le faisceau lumineux définissant la zone utilisée par la lumière entre au moins deux coques de miroir.

3. Collecteur selon la revendication 1 ou 2, **caractérisé en ce que** les autres composants comprennent des moyens de détection et/ou des miroirs de découplage et/ou des éléments sans effet optique tels que des dispositifs de blindage et/ou des dispositifs de refroidissement (203.1, 203.2, 203.3, 1006.1, 1006.2, 1006.3) et/ou des dispositifs de fixation.

4. Collecteur selon l'une des revendications 1 à 3, **caractérisé en ce que** la zone à éclairer se trouve dans un plan (7) et se compose d'éléments annulaires (30, 32, 34, 230, 232, 234), chaque élément annulaire (30, 32, 34, 230, 232, 234) étant associé à un élément d'ouverture annulaire (20, 22, 24, 210, 212, 214) et l'extension en direction de l'axe de rotation, les paramètres de superficie et la position des coques de miroir étant choisis de telle façon que les intensités d'irradiation des différents éléments annulaires dans le plan (7) coïncident dans une grande mesure.

5. Collecteur selon la revendication 4, **caractérisé en ce que** les éléments annulaires (30, 32, 34, 230, 232, 234) se raccordent les uns aux autres de façon continue.

6. Collecteur selon l'une des revendications 1 à 5, **caractérisé en ce qu'**au moins deux éléments d'ouverture annulaires (20, 22, 24, 210, 212, 214) ne se raccordent pas l'un à l'autre de façon continue et une lacune (26, 220, 222) est formée entre ceux-ci.

7. Collecteur selon la revendication 6, **caractérisé en ce que** les autres composants, en particulier les éléments n'ayant pas d'effet optique, en particulier les dispositifs de refroidissement (203.1, 203.2, 203.3, 1006.1, 1006.2, 1006.3), sont disposés au niveau des lacunes (26, 220, 222) des éléments d'ouverture annulaires.

8. Collecteur selon l'une des revendications 1 à 7, **caractérisé en ce que** les coques de miroir sont des segments annulaires d'asphères.

9. Collecteur selon la revendication 8, **caractérisé en ce que** les coques de miroir sont un segment annulaire d'une ellipsoïde ou d'une paraboloïde ou d'une hyperboloïde.

10. Collecteur selon l'une des revendications 1 à 7, **caractérisé en ce qu'**au moins une coque de miroir (200, 202, 204) comprend un premier segment (200.1, 202.1, 204.1) avec une première surface optique (200.2, 202.2, 204.2) et un deuxième segment (200.3, 202.3, 204.3) avec une deuxième surface optique (200.4, 202.4, 204.4).

11. Collecteur selon la revendication 10, **caractérisé en ce que** la première surface optique et la deuxième surface optique d'une coque de miroir ne se raccordent pas l'une à l'autre de façon continue et une lacune est formée entre la première surface optique et la deuxième surface optique d'une coque de miroir.

12. Collecteur selon la revendication 11, **caractérisé en ce que** les autres composants, en particulier les dispositifs de refroidissement (203.1, 203.2, 203.3, 1006.1, 1006.2, 1006.3), sont disposés dans la lacune entre une première surface optique et une deuxième surface optique de la coque de miroir.

13. Collecteur selon l'une des revendications 10 à 12, **caractérisé en ce que** le premier segment annulaire est un segment d'une hyperboloïde et le deuxième segment annulaire un segment d'une ellipsoïde.

14. Collecteur selon l'une des revendications 10 à 12, **caractérisé en ce que** le premier segment annulaire est un segment d'une hyperboloïde et le deuxième segment annulaire un segment d'une paraboloïde.

15. Collecteur selon l'une des revendications 1 à 14, **caractérisé en ce que** les dispositifs de refroidissement comprennent des canaux de refroidissement qui sont parcourus par un fluide réfrigérant.

**16.** Collecteur selon l'une des revendications 1 à 15, **caractérisé en ce que** le collecteur comprend des dispositifs de maintien (1202.1, 1202.2, 1202.3, 1202.4).

**17.** Collecteur selon la revendication 16, **caractérisé en ce que** les dispositifs de maintien comprennent des rayons de soutien (1204.1, 1204.2, 1204.3, 1204.4) qui s'étendent dans le sens radial des coques de miroir.

**18.** Collecteur selon la revendication 17, **caractérisé en ce que** les dispositifs de refroidissement comprennent des dispositifs d'arrivée et d'évacuation du fluide réfrigérant et les dispositifs d'arrivée et d'évacuation sont disposés au niveau des dispositifs de maintien.

**19.** Collecteur selon l'une des revendications 1 à 18, **caractérisé en ce que** les rayons du faisceau de rayonnement provenant de la source lumineuse touchent la tangente de surface des coques de miroir sous des angles d'incidence < 20˚.

**20.** Système d'éclairage ayant une longueur d'ondes ≤ 193 nm, de préférence ≤ 126 nm, en particulier des longueurs d'ondes dans les UVE, avec :

   une source lumineuse (1) ;
   au moins un collecteur (3) ;
   un plan à éclairer (7, 103),

   **caractérisé en ce que** le collecteur est un collecteur (3) selon l'une des revendications 1 à 20.

**21.** Système d'éclairage ayant une longueur d'ondes ≤ 193 nm, de préférence ≤ 126 nm, en particulier des longueurs d'ondes dans les UVE, selon la revendication 20, **caractérisé en ce que** le système d'éclairage comprend en outre un premier élément optique (120) comprenant des premiers éléments de grille (150).

**22.** Système d'éclairage ayant une longueur d'ondes ≤ 193 nm, de préférence ≤ 126 nm, en particulier des longueurs d'ondes dans les UVE, selon la revendication 21, **caractérisé en ce que** le collecteur (3) éclaire une zone annulaire dans le plan (7, 103) à éclairer et **en ce que** les premiers éléments de grille (150) du premier élément optique (102) disposé dans le plan à éclairer (7, 103) sont disposés approximativement à l'intérieur de la zone annulaire.

**23.** Système d'éclairage ayant une longueur d'ondes ≤ 193 nm, de préférence ≤ 126 nm, en particulier des longueurs d'ondes dans les UVE, selon la revendication 21 ou 22, **caractérisé en ce que** le système d'éclairage comprend en outre des éléments optiques (106, 108, 110) pour la formation d'une image et/ou la formation d'un champ.

**24.** Système d'éclairage ayant une longueur d'ondes ≤ 193 nm, de préférence ≤ 126 nm, en particulier des longueurs d'ondes dans les UVE, selon l'une des revendications 21 à 23, **caractérisé en ce que** le système d'éclairage comprend entre le collecteur (3) et le plan à éclairer (103) un plan conjugué à la source lumineuse (1) dans lequel une image intermédiaire (Z) de la source lumineuse (1) est formée.

**25.** Système d'éclairage ayant une longueur d'ondes ≤ 193 nm, de préférence ≤ 126 nm, en particulier des longueurs d'ondes dans les UVE, selon la revendication 24, **caractérisé en ce qu'**il est prévu dans ou près de l'image intermédiaire (Z) un obturateur (202) qui sépare dans l'espace et/ou en termes de pression un espace comprenant au moins la source lumineuse (1) et le collecteur (3) du système d'éclairage qui leur fait suite.

**26.** Installation d'exposition par projection à UVE avec :

   un système d'éclairage selon l'une des revendications 19 à 24 ;
   un masque qui est éclairé par le système d'éclairage ;
   un objectif de projection (126) pour la formation de l'image du masque sur
   un objet photosensible.

**27.** Procédé de fabrication de composants microélectroniques avec une installation d'exposition par projection à UVE selon la revendication 26, dans lequel un masque est éclairé et son image formée sur un objet photosensible.

Fig.1

Fig.2

$\alpha_4 = \text{arcsin} ( NA (\text{max}) )$

$\alpha_3 = \alpha_2 + d\alpha_2$

$\alpha_2$

$\alpha_1 + d\alpha_1$

$\alpha_1 = \text{arcsin} ( NA (\text{min}) )$

Fig.3

Fig.4

Fig.5

Fig.6

Fig.7

Fig.8

## Fig.9

Maximum($\delta(\beta)$) = 1

Mittelwert ($\beta$) = 4.86

$\beta$

Bildseitiger Aperturwinkel [°]

## Fig.10

$\beta$

$\beta$-ideal

$\beta$

Höhe in Ebene 7 [mm]
in radialer Richtung

Fig.11

Fig.12

Fig.13

Fig.14

Fig.15

EP 1 354 325 B1

33

Fig.16

Fig.17

Fig.18

Fig.19

Fig.20

Fig.21

Fig.22

Fig.23

Fig.24

Fig.25

Fig.26

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

### In der Beschreibung aufgeführte Patentdokumente

- US 5768339 A
- US 1865441 A
- US 5763930 A
- US 5745547 A
- DE 3001059 C2
- DE 3001059
- WO 9927542 A
- US 6064072 A
- WO 0063922 A

- WO 0108162 A
- DE 19903807
- WO 9957732 A
- US 5192869 A
- US 6198793 B1
- EP 0007258 W
- US 6244717 B1
- US 09503640 B
- WO 0109684 A

### In der Beschreibung aufgeführte Nicht-Patentliteratur

- **Wolter.** Annalen der Physik. 1952, vol. 10, 94-114
- *J. Optics,* 1984, vol. 15, 270-280

- **Naumann ; Schröder.** Bauelemente der Optik. Hauser-Verlag, 1992, 28-29